# EUROPEAN PATENT APPLICATION

(11) **EP 4 772 667 A1**
(43) Date of publication of application: **08.07.2026**
(21) Application number: 24859838.5
(22) Date of filing: 28.08.2024
(51) Int. Cl.: C23C 14/04, C23F 1/00, C23F 1/02, H10K 50/00, H10K 59/10, H10K 71/16

(54) **MASK AND METHOD FOR PRODUCING MASK**

(30) Priority: 30.08.2023 JP 2023140385
(71) Applicant: Dai Nippon Printing Co., Ltd., Tokyo 162-8001 (JP)
(72) Inventor: HASHIMOTO Katsumi, Tokyo 162-8001 (JP)
(74) Representative: Müller-Boré & Partner Patentanwälte PartG mbB
(86) International application number: PCT/JP2024/030739
(87) International publication number: WO 2025/047808

(57) **Abstract**

A mask may include a base material that includes a base-material first surface, a base-material second surface located opposite the base-material first surface, and at least one first opening that extends from the base-material first surface to the base-material second surface, and a multilayer body including a magnetic layer that includes a first surface facing the base-material second surface and a second surface located opposite the first surface and that contains magnetic metal and a non-magnetic layer located between the magnetic layer and the first surface or between the magnetic layer and the second surface. The multilayer body may include a pattern region that overlaps the first opening in plan view and that includes multiple second openings extending through the magnetic layer and the non-magnetic layer, a surrounding region that surrounds the pattern region in plan view, and an outer edge region that surrounds the surrounding region in plan view and that is located along an outer edge of the multilayer body.

## Description

### Technical Field

An embodiment of the present disclosure relates to a mask and a method of manufacturing a mask.

### Background Art

A vapor deposition method is known as a method of forming a precise pattern. In the vapor deposition method, a mask that includes an opening is combined with a substrate. Subsequently, a vapor deposition material is attached to the substrate via the opening of the mask. As a result, a vapor deposition layer that contains the vapor deposition material is formed on the substrate in a pattern that corresponds to the pattern of the opening of the mask. For example, the vapor deposition method is used as a method of forming pixels of an organic EL display device.

For example, PTL 1 discloses a vapor deposition mask that includes an outer frame substrate including a beam portion for defining multiple pixel areas and a mask substrate having multiple openings in the pixel areas. The mask substrate is thinner than the outer frame substrate. For example, the thickness of the mask substrate ranges from 1 µm to 100 µm, and the thickness of the outer frame substrate ranges from 100 µm to 775 µm.

### Citation List

### Patent Literature

PTL 1: Japanese Unexamined Patent Application Publication No. 2022-175723

### Summary of Invention

### Technical Problem

The mask substrate is thin, and accordingly, the dimensions or positions of the openings of the mask substrate are likely to change due to, for example, a change in temperature. As the dimensions or positions of the openings change, the dimensions or position of a vapor deposition layer that is formed on the substrate change.

### Solution to Problem

A mask according to an embodiment of the present disclosure may include a base material that includes a base-material first surface, a base-material second surface located opposite the base-material first surface, and at least one first opening that extends from the base-material first surface to the base-material second surface, and a multilayer body including a magnetic layer that includes a first surface facing the base-material second surface and a second surface located opposite the first surface and that contains magnetic metal and a non-magnetic layer located between the magnetic layer and the first surface or between the magnetic layer and the second surface. The multilayer body may include a pattern region that overlaps the first opening in plan view and that includes multiple second openings extending through the magnetic layer and the non-magnetic layer, a surrounding region that surrounds the pattern region in plan view, and an outer edge region that surrounds the surrounding region in plan view and that is located along an outer edge of the multilayer body.

### Advantageous Effects of Invention

According to an embodiment of the present disclosure, the dimensions or position of an opening can be inhibited from changing.

### Brief Description of Drawings

[Fig. 1] Fig. 1 is a sectional view of an example of an organic device.
[Fig. 2] Fig. 2 illustrates an example of a vapor deposition apparatus that includes a mask.
[Fig. 3] Fig. 3 is a plan view of an example of the mask when viewed from a position in front of an entrance surface.
[Fig. 4] Fig. 4 is a plan view of an example of the mask when viewed from a position in front of an exit surface.
[Fig. 5] Fig. 5 is a sectional view of the mask taken along a line V-V in Fig. 3.
[Fig. 6] Fig. 6 is a sectional view of an example of a pattern region.
[Fig. 7] Fig. 7 is a sectional view of an example of a surrounding region.
[Fig. 8] Fig. 8 is a sectional view of an example of an outer edge region.
[Fig. 9] Fig. 9 is a sectional view of an example of a step of forming a second intermediate layer.
[Fig. 10] Fig. 10 is a sectional view of an example of a step of forming a first non-magnetic layer.
[Fig. 11A] Fig. 11A is a sectional view of an example of a step of forming a through-hole in the first non-magnetic layer.
[Fig. 11B] Fig. 11B is a plan view of an example of a step of forming a through-hole in a first insulating layer.
[Fig. 12A] Fig. 12A is a sectional view of an example of a step of forming a first intermediate layer.
[Fig. 12B] Fig. 12B is a plan view of an example of the step of forming the first intermediate layer.
[Fig. 13A] Fig. 13A is a sectional view of an example of a step of forming an insulating layer.
[Fig. 13B] Fig. 13B is a plan view of an example of the step of forming the insulating layer.
[Fig. 14A] Fig. 14A is a sectional view of an example of a step of forming a magnetic layer.
[Fig. 14B] Fig. 14B is a sectional view of an example of the magnetic layer.
[Fig. 15] Fig. 15 is a sectional view of an example of a polishing step.
[Fig. 16] Fig. 16 is a sectional view of an example of a step of forming a first protection layer.
[Fig. 17] Fig. 17 is a sectional view of an example of a step of removing a portion of the insulating layer.
[Fig. 18] Fig. 18 is a sectional view of an example of a step of forming a second protection layer and a resist layer.
[Fig. 19] Fig. 19 is a sectional view of an example of a step of processing a base material.
[Fig. 20] Fig. 20 is a sectional view of an example of a step of removing a portion of the second intermediate layer.
[Fig. 21] Fig. 21 is a sectional view of an example of a step of removing a portion of the first intermediate layer.
[Fig. 22] Fig. 22 is a sectional view of an example of a step of removing the second protection layer and the resist layer.
[Fig. 23] Fig. 23 is a sectional view of an example of a magnetic layer according to a first modification.
[Fig. 24] Fig. 24 is a sectional view of an example of a step of forming an insulating layer according to the first modification.
[Fig. 25] Fig. 25 is a sectional view of an example of a step of forming a first layer according to the first modification.
[Fig. 26] Fig. 26 is a sectional view of an example of a step of forming a second layer according to the first modification.
[Fig. 27] Fig. 27 is a sectional view of an example of a polishing step according to the first modification.
[Fig. 28] Fig. 28 is a sectional view of an example of a pattern region according to a second modification.
[Fig. 29] Fig. 29 is a sectional view of an example of a step of forming a second non-magnetic layer according to the second modification.
[Fig. 30] Fig. 30 is a sectional view of an example of a step of forming a through-hole in the second non-magnetic layer according to the second modification.
[Fig. 31] Fig. 31 is a sectional view of an example of a pattern region according to a third modification.
[Fig. 32] Fig. 32 is a sectional view of an example of a polishing step according to the third modification.
[Fig. 33] Fig. 33 is a sectional view of an example of a step of forming a second non-magnetic layer according to the third modification.
[Fig. 34A] Fig. 34A is a sectional view of an example of a mask according to a fourth modification.
[Fig. 34B] Fig. 34B is a plan view of an example of the mask according to the fourth modification.
[Fig. 35A] Fig. 35A is a sectional view of an example of a step of forming an insulating layer according to the fourth modification.
[Fig. 35B] Fig. 35B is a plan view of an example of the step of forming the insulating layer according to the fourth modification.
[Fig. 36A] Fig. 36A is a sectional view of an example of a mask according to a fifth modification.
[Fig. 36B] Fig. 36B is a plan view of an example of the mask according to the fifth modification.
[Fig. 37A] Fig. 37A is a sectional view of an example of a step of forming an insulating layer according to the fifth modification.
[Fig. 37B] Fig. 37B is a plan view of an example of the step of forming the insulating layer according to the fifth modification.
[Fig. 38] Fig. 38 illustrates an example of a device that includes an organic device.

### Description of Embodiments

In the present specification and the drawings, words such as a "substrate", a "sheet", and a "film" that mean a substance on which a structure is based are not distinguished from each other only based on different names unless there is a particular description.

In the present specification and the drawings, words such as "parallel" and "perpendicular" and the values of a length and an angle that specify shapes, geometrical conditions, and the degree of these, for example, are not limited by strict meaning but are interpreted to an extent that the same function may be expected unless there is a particular description.

In some cases where a component such as a member or a region is "on" or "under", "on an upper side of" or "on a lower side of", or "above" or "below" another component such as another member or another region in the present specification and the drawings, the cases include a case where the component is in direct contact with the other component unless there is a particular description. The cases also include a case where another component is between the component and the other component, that is, a case where the component and the other component are indirectly connected to each other. As for the words "on", "upper side", and "above", or "under", "lower side", and "below", an up-down direction may be reversed unless there is a particular description.

In the case where multiple candidates of the upper limit and multiple candidates of the lower limit regarding a parameter are taken in the present specification, the numerical range of the parameter may include a combination of a freely selected one of the candidates of the upper limit and a freely selected one of the candidates of the lower limit. For example, the case of the description that "for example, a parameter B is A1 or more, may be A2 or more, or may be A3 or more. For example, the parameter B is A4 or less, may be A5 or less, or may be A6 or less" is considered. In this case, the numerical range of the parameter B may be A1 or more and A4 or less, may be A1 or more and A5 or less, may be A1 or more and A6 or less, may be A2 or more and A4 or less, may be A2 or more and A5 or less, may be A2 or more and A6 or less, may be A3 or more and A4 or less, may be A3 or more and A5 or less, or may be A3 or more and A6 or less.

In the present specification and the drawings, a state in which a surface of an element A "faces" a surface of an element B includes not only the case where the surface of the element A is in contact with the surface of the element B but also the case where an element C is located between the surface of the element A and the surface of the element B unless there is a particular description. That is, the term "face" represents the directions of two surfaces.

In the present specification and the drawings, like portions or portions that have the same function are designated by like reference signs or similar reference signs unless there is a particular description, and a duplicated description for these is omitted in some cases. For convenience of description, the ratio of dimensions in the drawings differs from an actual ratio, and an illustration of a portion of a component is omitted in the drawings in some cases.

In the present specification and the drawings, an embodiment in the present specification can be combined with another example without contradiction unless there is a particular description. Also, other examples can be combined with each other without contradiction.

In the case where two or more steps or processes related to a method such as a manufacturing method are disclosed in the present specification and the drawings, another step or process that is not disclosed may be performed between the disclosed steps or processes unless there is a particular description. The order of the disclosed steps or processes is freely determined without contradiction.

In an example described according to an embodiment of the present specification, a mask is used to form an organic layer or an electrode on a substrate when an organic EL display device is manufactured. However, the use of the mask is not particularly limited, and the present embodiment can be used for masks that are used in various ways. For example, the mask according to the present embodiment may be used to form an electrode of a device that displays or projects an image or a picture for expressing virtual reality, so-called VR, or augmented reality, so-called AR. In addition, the mask according to the present embodiment may be used to form an electrode of a display device other than an organic EL display device such as an electrode of a liquid-crystal display device. In addition, the mask according to the present embodiment may be used to form an electrode of an organic device other than a display device such as an electrode of a pressure sensor.

A mask according to a first aspect of the present disclosure includes
a base material that includes a base-material first surface, a base-material second surface located opposite the base-material first surface, and
at least one first opening that extends from the base-material first surface to the base-material second surface, and a multilayer body including a magnetic layer that includes a first surface facing the base-material second surface and a second surface located opposite the first surface and that contains magnetic metal and a non-magnetic layer located between the magnetic layer and the first surface or between the magnetic layer and the second surface.

The multilayer body includes a pattern region that overlaps the first opening in plan view and that includes multiple second openings extending through the magnetic layer and the non-magnetic layer, a surrounding region that surrounds the pattern region in plan view, and an outer edge region that surrounds the surrounding region in plan view and that is located along an outer edge of the multilayer body.

According to a second aspect of the present disclosure, the mask according to the first aspect described above may have an aspect described below. The non-magnetic layer may have an insulation property.

According to a third aspect of the present disclosure, the mask according to the first aspect or the second aspect described above may have an aspect described below. The non-magnetic layer may contain a silicon oxide or a silicon nitride.

According to a fourth aspect of the present disclosure, the mask according to any one of the first aspect to the third aspect described above may have an aspect described below. The base material may contain silicon or a silicon compound.

According to a fifth aspect of the present disclosure, the mask according to any one of the first aspect to the fourth aspect described above may have an aspect described below. The non-magnetic layer may include a first non-magnetic layer that is located between the magnetic layer and the first surface.

According to a sixth aspect of the present disclosure, the mask according to the fifth aspect described above may have an aspect described below. The multilayer body may include a first intermediate layer that is located between the first non-magnetic layer and the magnetic layer and that contains metal.

According to a seventh aspect of the present disclosure, the mask according to the fifth aspect or the sixth aspect described above may have an aspect described below. The surrounding region of the multilayer body may contain a second intermediate layer that is located between the first non-magnetic layer and the base-material second surface.

According to an eighth aspect of the present disclosure, the mask according to any one of the first aspect to the seventh aspect described above may have an aspect described below. The surrounding region of the multilayer body may contain an insulating layer that is flush with the magnetic layer of the pattern region.

According to a ninth aspect of the present disclosure, the mask according to the eighth aspect described above may have an aspect described below. The insulating layer in the surrounding region may include multiple insulating portions that are distributed in a plane direction of the base-material second surface, and the surrounding region may contain the magnetic layer that is located in gaps of the multiple insulating portions.

According to a tenth aspect of the present disclosure, the mask according to any one of the first aspect to the ninth aspect described above may have an aspect described below. The non-magnetic layer may include a second non-magnetic layer that is located between the magnetic layer and the second surface.

According to an eleventh aspect of the present disclosure, a method of manufacturing a mask includes
a base material preparation step of preparing a base material that includes a base-material first surface and a base-material second surface located opposite the base-material first surface,
a first non-magnetic layer formation step of forming a first non-magnetic layer that faces the base-material second surface and that includes multiple through-holes,
an insulating layer formation step of forming an insulating layer that includes multiple insulating portions overlapping the respective through-holes of the first non-magnetic layer in plan view,
a magnetic layer formation step of forming a magnetic layer in gaps of the multiple insulating portions,
an insulating layer removal step of removing the multiple insulating portions, and
a base material processing step of forming, in the base material, a first opening that overlaps the multiple through-holes of the first non-magnetic layer in plan view.

According to a twelfth aspect of the present disclosure, the method according to the eleventh aspect described above may have an aspect described below. The method may include a step of forming a first intermediate layer that covers the first non-magnetic layer and that contains metal, and at the insulating layer formation step, the insulating layer may be formed on the first intermediate layer.

According to a thirteenth aspect of the present disclosure, the method according to the eleventh aspect or the twelfth aspect described above may have an aspect described below. The method may include a step of forming a second intermediate layer that is located on the base-material second surface, and at the first non-magnetic layer formation step, the first non-magnetic layer may be formed on the second intermediate layer.

According to a fourteenth aspect of the present disclosure, the method according to the eleventh aspect to the thirteenth aspect described above may have an aspect described below. The first non-magnetic layer may contain a silicon oxide or a silicon nitride.

According to a fifteenth aspect of the present disclosure, a method of manufacturing a mask includes
a base material preparation step of preparing a base material that includes a base-material first surface and a base-material second surface located opposite the base-material first surface,
a first non-magnetic layer formation step of forming a first non-magnetic layer that faces the base-material second surface and that includes multiple through-holes,
an insulating layer formation step of forming an insulating layer that includes multiple insulating portions overlapping the respective through-holes of the first non-magnetic layer in plan view,
a magnetic layer formation step of forming a magnetic layer in gaps of the multiple insulating portions,
an insulating layer removal step of removing the multiple insulating portions, and
a base material processing step of forming, in the base material, a first opening that overlaps the multiple through-holes of the first non-magnetic layer in plan view.

According to a sixteenth aspect of the present disclosure, the method according to the fifteenth aspect described above may have an aspect described below. The method may include a step of forming an intermediate layer that is located on the base-material second surface and that contains metal, and at the insulating layer formation step, the insulating layer may be formed on the intermediate layer.

According to a seventeenth aspect of the present disclosure, the method according to the fifteenth aspect or the sixteenth aspect described above may have an aspect described below. The second non-magnetic layer may contain a silicon oxide or a silicon nitride.

According to an eighteenth aspect of the present disclosure, the method according to the eleventh aspect to the seventeenth aspect described above may have an aspect described below. The base material may contain silicon or a silicon compound.

According to a nineteenth aspect of the present disclosure, the method according to the eleventh aspect to the eighteenth aspect described above may have an aspect described below. At the insulating layer removal step, the insulating layer may remain so as not to overlap the first opening in plan view.

According to a twentieth aspect of the present disclosure, the method according to the nineteenth aspect described above may have an aspect described below. The insulating layer that remains after the insulating layer removal step may include multiple insulating portions that are distributed in a plane direction of the base-material second surface.

An embodiment of the present disclosure will be described in detail with reference to the drawings. The embodiment described later is an example of an embodiment of the present disclosure, and the present disclosure is not interpreted so as to be limited only to the embodiment.

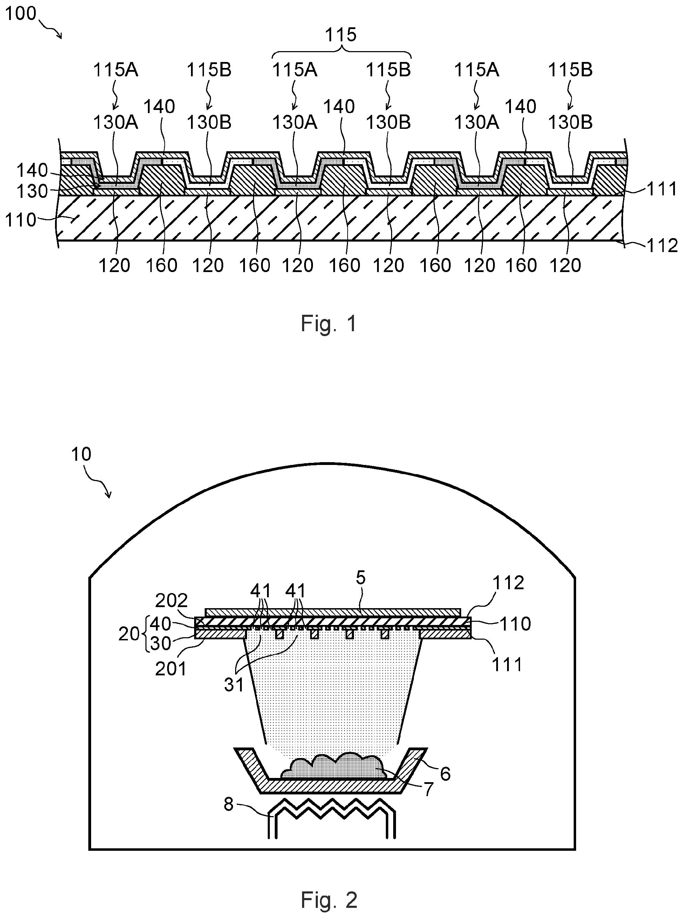

An organic device 100 that includes an organic layer that is formed by using a mask will be described. The organic device 100 includes an electrode or the organic layer that is formed by using the mask. Fig. 1 is a sectional view of an example of the organic device 100.

The organic device 100 includes a substrate 110 and multiple elements 115 that are arranged in an in-plane direction of the substrate 110. The substrate 110 includes a first surface 111 and a second surface 112 that is located opposite the first surface 111. The elements 115 are located on the first surface 111. Examples of the elements 115 are pixels. The substrate 110 may include two or more kinds of the elements 115. For example, the substrate 110 may include first elements 115A and second elements 115B. The substrate 110 may include third elements although this is not illustrated. For example, the first elements 115A, the second elements 115B, and the third elements are red pixels, blue pixels, and green pixels.

The elements 115 may include first electrodes 120, organic layers 130 that are located on the first electrodes 120, and second electrodes 140 that are located on the organic layers 130.

The organic device 100 may include insulating layers 160 each of which is located between two of the first electrodes 120 adjacent to each other in plan view. For example, the insulating layers 160 contain polyimide. The insulating layers 160 may overlap end portions of the first electrodes 120. The words "in plan view" mean that an object is viewed in the normal direction of a surface of a plate member such as the substrate 110.

The substrate 110 may be an insulating member. Examples of the material of the substrate 110 can include members that lack flexibility such as silicon, quartz glass, Pyrex (registered trademark) glass, and a synthetic quartz plate and members that are flexible such as a resin film, an optical resin plate, and thin glass. The substrate 110 may have the same planar shape as that of a silicon wafer that is used for semiconductor manufacturing. In this case, the substrate 110 can be processed by using a device that performs a semiconductor manufacturing step. For example, the first electrodes 120 and the insulating layers 160 can be formed on the substrate 110 by using the device that performs the semiconductor manufacturing step.

The elements 115 are configured to fulfill a function in a manner in which a voltage is applied between the first electrodes 120 and the second electrodes 140 or a current flows between the first electrodes 120 and the second electrodes 140. For example, in the case where the elements 115 are pixels of an organic EL display device, the elements 115 are capable of emitting light for forming a picture.

The first electrodes 120 contain a conductive material. For example, the first electrodes 120 contain metal, a conductive metal oxide or another conductive inorganic material. The first electrodes 120 may contain a transparent, conductive metal oxide such as an indium tin oxide.

The organic layers 130 contain an organic material. When the organic layers 130 are energized, the organic layers 130 can perform a function. The phrase "to be energized" means that a voltage is applied to the organic layers 130, or a current flows through the organic layers 130. Examples of the organic layers 130 can include light-emitting layers that emit light when being energized and layers the refractive index or the optical transmittance of which changes when being energized. The organic layers 130 may contain an organic semiconductor material.

As illustrated in Fig. 1, the organic layers 130 may include first organic layers 130A and second organic layers 130B. The first organic layers 130A are included in the first elements 115A. The second organic layers 130B are included in the second elements 115B. The organic layers 130 may include third organic layers that are included in the third elements although these are not illustrated. For example, the first organic layers 130A, the second organic layers 130B, and the third organic layers are red light-emitting layers, blue light-emitting layers, and green light-emitting layers.

When a voltage is applied between the first electrodes 120 and the second electrodes 140, the organic layers 130 that are located therebetween are driven. In the case where the organic layers 130 are light-emitting layers, light is emitted from the organic layers 130, and the light exits from the second electrodes 140 or the first electrodes 120 to the outside.

The organic layers 130 may further include a hole injection layer, a hole transport layer, an electron transport layer, an electron injection layer, and another layer.

The second electrodes 140 may contain a conductive material such as metal. Examples of the material of the second electrodes 140 can include platinum, gold, silver, copper, iron, tin, chromium, aluminum, indium, lithium, sodium, potassium, calcium, magnesium, chromium, carbon, and alloys of these. As illustrated in Fig. 1, the second electrodes 140 may extend across two of the organic layers 130 adjacent to each other in plan view.

A method of forming the organic layers 130 on the substrate 110 by using the vapor deposition method will now be described. Fig. 2 illustrates a vapor deposition apparatus 10. The vapor deposition apparatus 10 performs a vapor deposition process in which a vapor deposition material is deposited on an object.

As illustrated in Fig. 2, the vapor deposition apparatus 10 may include a vapor deposition source 6, a heater 8, and a mask 20 therein. The vapor deposition apparatus 10 may further include an exhaust unit for creating a vacuum atmosphere in the vapor deposition apparatus 10. An example of the vapor deposition source 6 is a crucible. The vapor deposition source 6 contains a vapor deposition material 7 such as an organic material or a metal material. The heater 8 heats the vapor deposition source 6 and vaporizes the vapor deposition material 7 in the vacuum atmosphere.

The mask 20 includes an entrance surface 201, an exit surface 202, first openings 31, and second openings 41. The entrance surface 201 faces the vapor deposition source 6. The exit surface 202 is located opposite the entrance surface 201. The exit surface 202 faces the first surface 111 of the substrate 110. The first openings 31 are located at the entrance surface 201. The second openings 41 are located at the exit surface 202. The first openings 31 and the second openings 41 are connected to each other in the thickness direction of the mask 20. Multiple second openings 41 overlap one of the first openings 31 in plan view. The vapor deposition material 7 that enters the mask 20 via the entrance surface 201 partly passes through the first openings 31 and the second openings 41 and exits via the exit surface 202. The vapor deposition material 7 that exits via the exit surface 202 is attached to the first surface 111 of the substrate 110. The exit surface 202 of the mask 20 may be in contact with the first surface 111 of the substrate 110.

As illustrated in Fig. 2, the vapor deposition apparatus 10 may include a magnet 5 that is disposed so as to face the second surface 112 of the substrate 110. In the case where the mask 20 contains a magnetic material, the magnet 5 is capable of attracting the mask 20 toward the substrate 110 due to magnetic force. As a result, a gap between the mask 20 and the substrate 110 can be reduced or eliminated. As a result, shadow can be inhibited from occurring at a vapor deposition step. In the present application, the shadow means a phenomenon in which the thicknesses of the organic layers 130 that are formed near wall surfaces of the second openings 41 are less than the thicknesses of the organic layers 130 at the centers of the second openings 41. The shadow occurs, for example, due to the vapor deposition material 7 that is attached to a wall surface of the mask 20 or the vapor deposition material 7 that enters the gap between the mask 20 and the substrate 110.

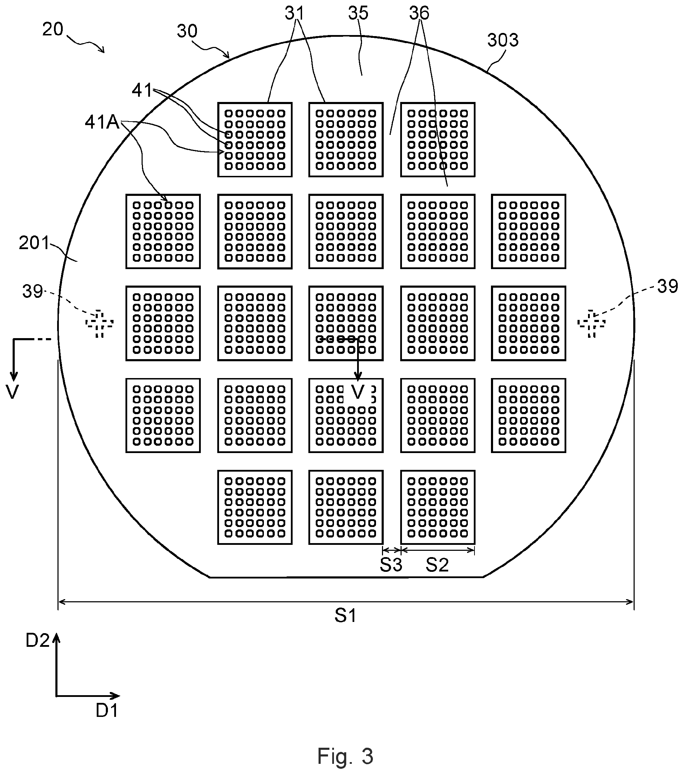

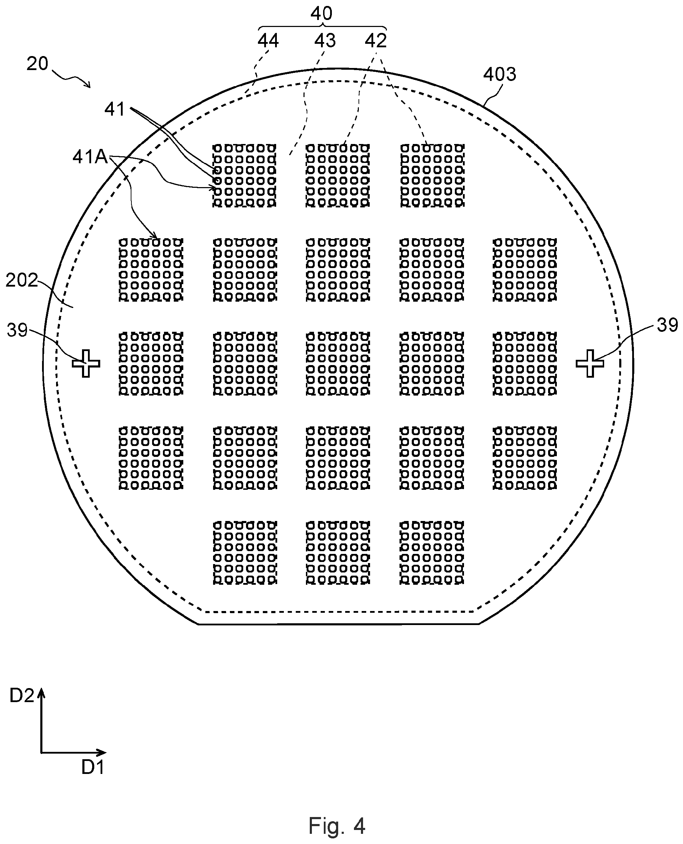

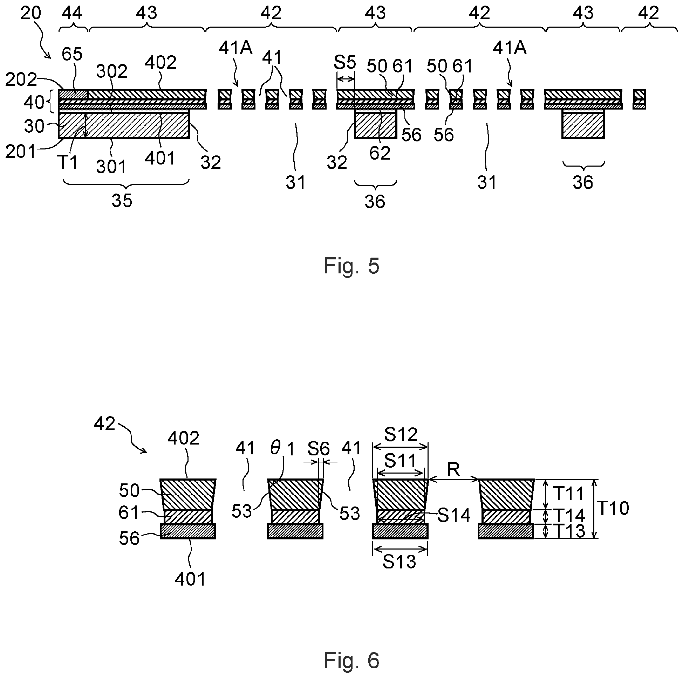

The mask 20 will now be described in detail. Fig. 3 is a plan view of an example of the mask 20 when viewed from a position in front of the entrance surface 201. Fig. 4 is a plan view of an example of the mask 20 when viewed from a position in front of the exit surface 202. Fig. 5 is a sectional view of the mask 20 taken along a line V-V in Fig. 3.

As illustrated in Fig. 5, the mask 20 includes a base material 30 and a multilayer body 40.

The base material 30 includes a base-material first surface 301, a base-material second surface 302, the first openings 31 and first wall surfaces 32. The base-material first surface 301 may form the entrance surface 201. The base-material second surface 302 is located opposite the base-material first surface 301. The first wall surfaces 32 are located between the base-material first surface 301 and the base-material second surface 302. The first wall surfaces 32 face the first openings 31.

The first openings 31 extend through the base material 30 from the base-material first surface 301 to the base-material second surface 302. As illustrated in Fig. 3, the base material 30 may include the multiple first openings 31. The multiple first openings 31 may be arranged in a first direction D1 and a second direction D2. The second direction D2 may be perpendicular to the first direction D1. The first direction D1 and the second direction D2 are parallel with the base-material first surface 301.

One of the first openings 31 may correspond to a single screen of an organic EL display device. The mask 20 that includes the multiple first openings 31 enables the pattern of an organic layer that corresponds to multiple screens to be simultaneously formed on the substrate 110. As illustrated in Fig. 3, the first openings 31 may have a rectangular contour in plan view.

The first wall surfaces 32 face the first openings 31. In an example illustrated in Fig. 5, the first wall surfaces 32 extend in the normal direction of the base-material first surface 301.

As illustrated in Fig. 3, a region of the base material 30 in which the first openings 31 are not formed may be divided into an outer region 35 and an inner region 36. The inner region 36 is located between two of the first openings 31 adjacent to each other in plan view. The outer region 35 is located between an outer edge 303 of the base material 30 and the first openings 31 in plan view. As illustrated in Fig. 3, the inner region 36 may extend in the first direction D1 and the second direction D2.

As illustrated in Fig. 3 and Fig. 4, the base material 30 may include alignment marks 39. For example, the alignment marks 39 are formed on the base-material second surface 302. The alignment marks 39 may be formed on the base-material first surface 301. For example, the alignment marks 39 are used to adjust the relative position of the substrate 110 with respect to the mask 20. In the case where the substrate 110 has properties that enable visible light to pass therethrough, the alignment marks 39 can be visually recognized through the substrate 110.

As illustrated in Fig. 3 and Fig. 4, the alignment marks 39 may have a cross-shaped contour in plan view. The alignment marks 39 may have a contour that has another shape other than a cross shape such as a rectangular shape or a circular shape although this is not illustrated. The alignment marks 39 may be located in the outer region 35 or may be located in the inner region 36.

The shapes of the alignment marks 39 in sectional view are freely determined. For example, the alignment marks 39 may include recessed portions that are located on the base-material first surface 301 or the base-material second surface 302. The alignment marks 39 may have holes that extend from the base-material first surface 301 to the base-material second surface 302. The recessed portions and the holes may be formed by etching the base-material first surface 301 or the base-material second surface 302. The recessed portions and the holes may be formed in a manner in which the base-material first surface 301 or the base-material second surface 302 is irradiated with a laser. For example, the alignment marks 39 may include layers that are located on the base-material first surface 301 or the base-material second surface 302. The layers are composed of a material that differs from that of the base material 30. The alignment marks 39 may be formed on a layer other than the base material 30.

The base material 30 contains silicon or a silicon compound. For example, the base material 30 is manufactured by processing a silicon wafer. As illustrated in Fig. 3, the outer edge 303 of the base material 30 may include a straight portion. The straight portion is also referred to as an orientation flat. The outer edge 303 may include a cut portion although this is not illustrated. The cut portion is also referred to as a notch. The orientation flat and the notch represent the crystal orientation of the silicon wafer.

For example, the maximum dimension S1 of the base material 30 in plan view is 100 mm or more, may be 150 mm or more, or may be 200 mm or more. For example, the dimension S1 is 500 mm or less, may be 400 mm or less, or may be 300 mm or less.

For example, the dimension S2 of each first opening 31 in a direction in which each first opening 31 is arranged is 5 mm or more, may be 10 mm or more, or may be 20 mm or more. For example, the dimension S2 is 100 mm or less, may be 50 mm or less, or may be 30 mm or less.

For example, an interval S3 between two of the first openings 31 in the direction in which the first openings 31 are arranged is 0.1 mm or more, may be 0.5 mm or more, or may be 1.0 mm or more. For example, the interval S3 is 20 mm or less, may be 15 mm or less, or may be 10 mm or less.

The thickness of the base material 30 is defined as the maximum thickness T1 of the outer region 35. For example, the thickness T1 is 50 µm or more, may be 100 µm or more, or may be 200 µm or more. For example, the thickness T1 is 1000 µm or less, may be 800 µm or less, or may be 600 µm or less.

The multilayer body 40 will now be described. As illustrated in Fig. 5, the multilayer body 40 includes a first surface 401 and a second surface 402. The first surface 401 faces the first openings 31 or the base-material second surface 302 of the base material 30. The second surface 402 is located opposite the first surface 401 in the thickness direction of the base material 30.

The multilayer body 40 includes multiple through-hole groups 41A that are arranged along the base-material first surface 301. For example, the multiple through-hole groups 41A may be arranged in the first direction D1 and the second direction D2 as in the multiple first openings 31. The through-hole groups 41A overlap the first openings 31 in plan view. One of the through-hole groups 41A may overlap one of the first openings 31.

The through-hole groups 41A include the multiple second openings 41. Multiple second openings 41 of one of the through-hole groups 41A may overlap one of the first openings 31 in plan view. As illustrated in Fig. 5, the second openings 41 extend through the multilayer body 40 from the first surface 401 to the second surface 402.

One of the second openings 41 corresponds to a single vapor deposition layer. For example, the single vapor deposition layer is one of the organic layers 130. A group of multiple second openings 41 that are included in one of the through-hole groups 41A may correspond to a single screen of an organic EL display device.

As illustrated in Fig. 4 and Fig. 5, the multilayer body 40 may have pattern regions 42, surrounding region(s) 43, and an outer edge region 44 in plan view. In other words, the multilayer body 40 may be divided into the multiple pattern regions 42, the surrounding region(s) 43, and the outer edge region 44 in plan view. The pattern regions 42 contain the multiple second openings 41 that overlap the first openings 31 in plan view. One of the pattern regions 42 may correspond to one of the through-hole groups 41A. The surrounding region 43 surround the pattern region 42 in plan view. The single surrounding region 43 may surround the multiple pattern regions 42. The outer edge region 44 surrounds the surrounding region(s) 43 in plan view. The outer edge region 44 may be located along an outer edge 403 of the multilayer body 40. The outer edge region 44 may extend along the outer edge 403 of the multilayer body 40 so as to draw a circle.

The layer structure of the multilayer body 40 will be described. The multilayer body 40 includes at least a magnetic layer 50 and a non-magnetic layer. The magnetic layer 50 contains, as a main component, magnetic metal. The non-magnetic layer does not contain, as a main component, magnetic metal. For example, the non-magnetic layer contains, as a main component, an inorganic material that has insulation properties such as a silicon oxide or a silicon nitride. A main component means a material that constitutes 51 weight% or more of a layer.

At the vapor deposition step, the magnetic layer 50 is attracted toward the substrate due to the magnetic force of the magnet 5. The mask 20 includes the magnetic layer 50, and consequently, the gap between the mask 20 and the substrate 110 is reduced. In the case where the mask 20 includes the magnetic layer 50, the dimensions or position of an opening that is formed in the magnetic layer 50 are likely to change. For example, it is thought that when the temperature of the mask 20 changes, the dimensions or position of the opening of the magnetic layer 50 change. It is thought that the cause of the change is that the coefficient of thermal expansion of the magnetic layer 50 is high.

In consideration of this issue, the present embodiment proposes that the pattern regions 42 of the multilayer body 40 include a non-magnetic layer that overlaps the magnetic layer 50 in plan view. The non-magnetic layer is a layer for inhibiting the magnetic layer 50 from changing due to, for example, a change in temperature. For example, the non-magnetic layer contains, as a main component, an inorganic material that has insulation properties such as a silicon oxide or a silicon nitride. The non-magnetic layer may have a coefficient of thermal expansion lower than the coefficient of thermal expansion of the magnetic layer 50.

The non-magnetic layer is located between the magnetic layer 50 and the first surface 401 or between the magnetic layer 50 and the second surface 402. In an example described according to the present embodiment, the non-magnetic layer is located between the magnetic layer 50 and the first surface 401. The non-magnetic layer that is located between the magnetic layer 50 and the first surface 401 is also referred to as a first non-magnetic layer and designated by using a reference sign of 56. The second openings 41 described above extend through the magnetic layer 50 and the first non-magnetic layer 56.

As illustrated in Fig. 5, the pattern regions 42 may include a first intermediate layer 61 that is located between the first non-magnetic layer 56 and the magnetic layer 50. The second openings 41 may extend through the magnetic layer 50, the first non-magnetic layer 56, and the first intermediate layer 61.

As illustrated in Fig. 5, the surrounding region(s) 43 and the outer edge region 44 may contain the first non-magnetic layer 56 and the first intermediate layer 61. The first non-magnetic layer 56 and the first intermediate layer 61 that are located in the surrounding region(s) 43 and the outer edge region 44 may have no through-holes. For example, the first non-magnetic layer 56 and the first intermediate layer 61 that are located in the surrounding region(s) 43 and the outer edge region 44 may extend without a gap. The surrounding region(s) 43 and the outer edge region 44 may contain a second intermediate layer 62 that is located between the first non-magnetic layer 56 and the base-material second surface 302.

As illustrated in Fig. 5, the surrounding region(s) 43 may contain a projecting portion that overlaps the first openings 31 in plan view. The projecting portion may not include the second intermediate layer 62. A reference sign of S5 represents a dimension of the projecting portion in plan view. The dimension S5 is defined by using an imaginary line that extends in the first direction D1 and that passes through the centers of the multiple second openings 41 in plan view. The dimension S5 may be larger than a dimension R of each second opening 41 described later.

As illustrated in Fig. 5, the outer edge region 44 may contain an insulating layer 65. The insulating layer 65 may be flush with the magnetic layer 50. For example, the insulating layer 65 and the magnetic layer 50 may be located on the first intermediate layer 61. The insulating layer 65 may have a side surface that faces a side surface of the magnetic layer 50 in the plane direction of the base-material second surface 302. The side surface of the insulating layer 65 may be in contact with the side surface of the magnetic layer 50.

The pattern regions 42, the surrounding region(s) 43, and the outer edge region 44 will be described in detail.

Fig. 6 is a sectional view of an example of a pattern region 42. The first surface 401 of the pattern region 42 may be formed by the first non-magnetic layer 56. The second surface 402 of the pattern region 42 may be formed by the magnetic layer 50.

A reference sign of S11 in Fig. 6 represents a dimension of the magnetic layer 50 at a lower surface. The "lower surface" means a surface that faces the first surface 401 in the thickness direction. A reference sign of S12 represents a dimension of the magnetic layer 50 at an upper surface. The "upper surface" represents a surface that faces the second surface 402 in the thickness direction. A reference sign of R represents a dimension of each second opening 41 at the second surface 402. The dimensions S11, S12, and R are defined by using an imaginary line that extends in the first direction D1 and that passes through the centers of the multiple second openings 41 in plan view.

The dimension S12 may be larger than the dimension S11. In other words, the dimension R of each second opening 41 at the upper surface of the magnetic layer 50 may be smaller than the dimension of each second opening 41 at the lower surface of the magnetic layer 50. When the dimension of each second opening 41 at the lower surface of the magnetic layer 50 is larger than the dimension R, shadow can be inhibited from occurring near the side surface of the magnetic layer 50.

For example, the dimension R is 1.0 µm or more, may be 2.0 µm or more, or may be 3.0 µm or more. For example, the dimension R is 25.0 µm or less, may be 10.0 µm or less, or may be 5.0 µm or less.

For example, the dimension S12 is 1.0 µm or more, may be 2.0 µm or more, or may be 3.0 µm or more. For example, the dimension S12 is 25.0 µm or less, may be 10.0 µm or less, or may be 5.0 µm or less.

As illustrated in Fig. 6, the side surface of the magnetic layer 50 may include tapered surfaces 53 that incline away from the centers of the second openings 41 as their positions approach the lower surface of the magnetic layer 50 from the upper surface. When the side surface of the magnetic layer 50 includes the tapered surfaces 53, the dimension S12 can be larger than the dimension S11.

In Fig. 6, a reference sign of S6 represents the width of each tapered surface 53. For example, the width S6 is 0.2 µm or more, may be 0.5 µm or more, or may be 1.0 µm or more. For example, the width S6 is 10.0 µm or less, may be 5.0 µm or less, or may be 3.0 µm or less.

In Fig. 6, a reference sign of θ1 represents an angle that is formed between the upper surface and the side surface of the magnetic layer 50. For example, the angle θ1 is 50° or more, may be 55° or more, or may be 60° or more. For example, the angle θ1 is less than 90°, may be 85° or less, or may be 80° or less.

In Fig. 6, a reference sign of S13 represents a dimension of the first non-magnetic layer 56 at the lower surface. A reference sign of S14 represents a dimension of the first intermediate layer 61 at the lower surface. The dimension S13 and the dimension S14 may be smaller than the dimension S12 of the upper surface of the magnetic layer 50. As the dimension S13 and the dimension S14 decrease, shadow due to the first non-magnetic layer 56 and the first intermediate layer 61 can be further inhibited from occurring. The dimensions S13 and S14 and the width S6 described above are defined by using an imaginary line that extends in the first direction D1 and that passes through the centers of the multiple second openings 41 in plan view.

The thickness T10 of each pattern region 42 is less than the thickness of the base material 30. For example, the thickness T10 is 25.0 µm or less, may be 10.0 µm or less, or may be 5.0 µm or less. This enables shadow to be inhibited from occurring. For example, the thickness T10 is 1.0 µm or more, may be 2.0 µm or more, or may be 3.0 µm or more.

The magnetic layer 50 contains magnetic metal. Examples of the magnetic metal include nickel, iron, cobalt, and alloys of these.

For example, the thickness T11 of the magnetic layer 50 is 10.0 µm or less, may be 5.0 µm or less, or may be 3.0 µm or less. When the thickness T11 of the magnetic layer 50 is 10.0 µm or less, shadow can be inhibited from occurring. For example, the thickness T11 is 0.5 µm or more, may be 1.0 µm or more, or may be 2.0 µm or more. When the thickness T11 of the magnetic layer 50 is 0.5 µm or more, the magnetic layer 50 can be inhibited, for example, from having a defect such as a pinhole and from deforming.

The first non-magnetic layer 56 is composed of a non-magnetic material. For example, the first non-magnetic layer 56 contains, as a main component, an inorganic material that has insulation properties such as a silicon oxide or a silicon nitride.

For example, the thickness T13 of the first non-magnetic layer 56 is 50 nm or more, may be 100 nm or more, or may be 200 nm or more. For example, the thickness T13 is 1000 nm or less, may be 700 nm or less, or may be 500 nm or less.

The thickness T13 of the first non-magnetic layer 56 may be defined relative to the thickness T11 of the magnetic layer 50 such that the magnetic layer 50 is inhibited from changing. For example, T13/T11 that is the ratio of the thickness T13 of the first non-magnetic layer 56 to the thickness T11 of the magnetic layer 50 is 0.05 or more, may be 0.10 or more, or may be 0.15 or more. For example, T13/T11 is 0.50 or less, may be 0.40 or less, or may be 0.30 or less.

The first intermediate layer 61 may function as a seed layer for forming the magnetic layer 50 by electroplating as described later. The first intermediate layer 61 may contain metal. Examples of the metal include nickel, copper, titanium, aluminum, and alloys of these. The first intermediate layer 61 may be composed of a single layer or multiple layers. For example, the first intermediate layer 61 may include a first layer that contains titanium and a second layer that is located between the first layer and the magnetic layer 50 and that contains nickel or copper.

For example, the thickness T14 of the first intermediate layer 61 is 20 nm or more, may be 50 nm or more, or may be 100 nm or more. For example, the thickness T14 is 500 nm or less, may be 300 nm or less, or may be 200 nm or less.

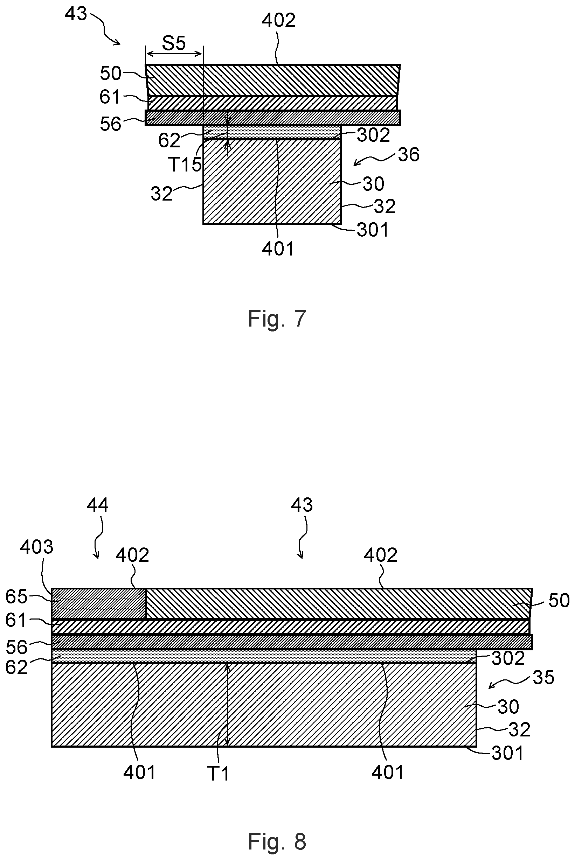

Fig. 7 is a sectional view of an example of a surrounding region 43. The first surface 401 of the surrounding region 43 may be formed by the second intermediate layer 62. The second surface 402 of the surrounding region 43 may be formed by the magnetic layer 50.

The second intermediate layer 62 may function as a layer for stopping etching at a step of processing the base material 30 by etching as described later. Specifically, the second intermediate layer 62 has resistance against an etchant for etching the base material 30. The second intermediate layer 62 may contain metal such as aluminum, an aluminum alloy, titanium, or a titanium alloy. For example, the aluminum alloy contains aluminum and neodymium. The second intermediate layer 62 may contain an inorganic compound such as a silicon oxide.

The thickness T15 of the second intermediate layer 62 is not particularly limited provided that the first intermediate layer 61 and the magnetic layer 50 are inhibited from being etched at the step of processing the base material 30. For example, the thickness of the second intermediate layer 62 may be less than the thickness of the magnetic layer 50. For example, the thickness T15 of the second intermediate layer 62 is 5 nm or more, may be 50 nm or more, or may be 75 nm or more. For example, the thickness T15 is 10.0 µm or less, may be 5.0 µm or less, may be 1.0 µm or less, may be 300 nm or less, or may be 150 nm or less. As the resistance of the second intermediate layer 62 against the etchant for the base material 30 becomes greater, the thickness T15 of the second intermediate layer 62 can be further decreased.

Fig. 8 is a sectional view of an example of the outer edge region 44. The first surface 401 of the outer edge region 44 may be formed by the second intermediate layer 62. The second surface 402 of the outer edge region 44 may be formed by the insulating layer 65.

The insulating layer 65 may have properties different from those of the magnetic layer 50 regarding stress. For example, in the case where the magnetic layer 50 applies tensile stress to the base material 30, the insulating layer 65 may apply compressive stress to the base material 30. In this case, the insulating layer 65 at least partly cancels out force that is applied by the magnetic layer 50 to the base material 30. For this reason, the mask 20 can be inhibited from warping.

The material of the insulating layer 65 may be selected such that the insulating layer 65 has properties different from those of the magnetic layer 50 regarding stress. The material of the insulating layer 65 has insulation properties. For example, the insulating layer 65 contains an oxide that has insulation properties. An example of the oxide is a silicon oxide.

The numerical range of the thickness of the insulating layer 65 may be equal to the numerical range of the thickness T11 of the magnetic layer 50 described above. The thickness of the insulating layer 65 may be equal to the thickness T11 of the magnetic layer 50.

The thicknesses of the layers, the dimensions of components, and widths, for example, are measured in a manner in which an image of a section of the mask 20 is observed by using a scanning electron microscope.

A method of manufacturing the mask 20 will now be described. A base material preparation step at which the base material 30 is prepared is first performed. The base material 30 may be a silicon wafer. The base-material first surface 301 and the base-material second surface 302 of the base material 30 may be polished into mirror surfaces. The arithmetic average roughness Ra of the base-material first surface 301 and the base-material second surface 302 may be 1.5 nm or less or may be 1.0 nm or less. For example, the plane orientations of the base-material first surface 301 and the base-material second surface 302 may be (100) and (110).

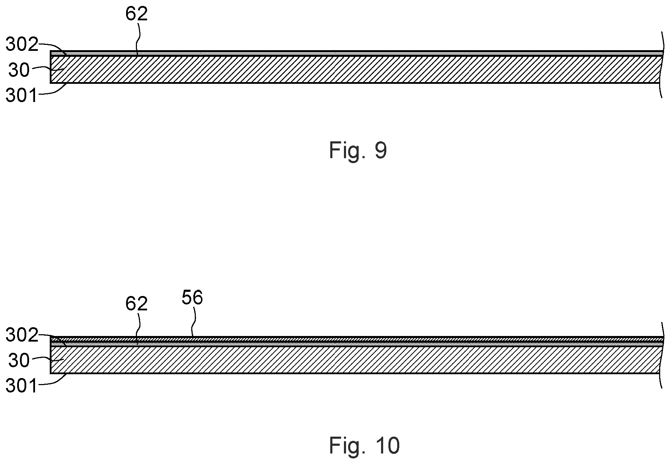

Subsequently, as illustrated in Fig. 9, the second intermediate layer 62 is formed on the base-material second surface 302 of the base material 30. The second intermediate layer 62 may be formed on the whole of the base-material second surface 302. For example, the second intermediate layer 62 may be formed by using a physical film formation method such as a sputtering method, a vapor deposition method, or an ion plating method.

Subsequently, as illustrated in Fig. 10, a first non-magnetic layer formation step at which the first non-magnetic layer 56 is formed is performed. At the first non-magnetic layer formation step illustrated in Fig. 10, the first non-magnetic layer 56 is formed on the second intermediate layer 62. The first non-magnetic layer 56 may be formed by using a chemical vapor deposition method. For example, in the case where the first non-magnetic layer 56 contains a silicon oxide, the first non-magnetic layer 56 may be formed by using the chemical vapor deposition method in which tetraethyl orthosilicate Si (OC₂H₅)₄ is used as a material. The tetraethyl orthosilicate is also referred to as TEOS.

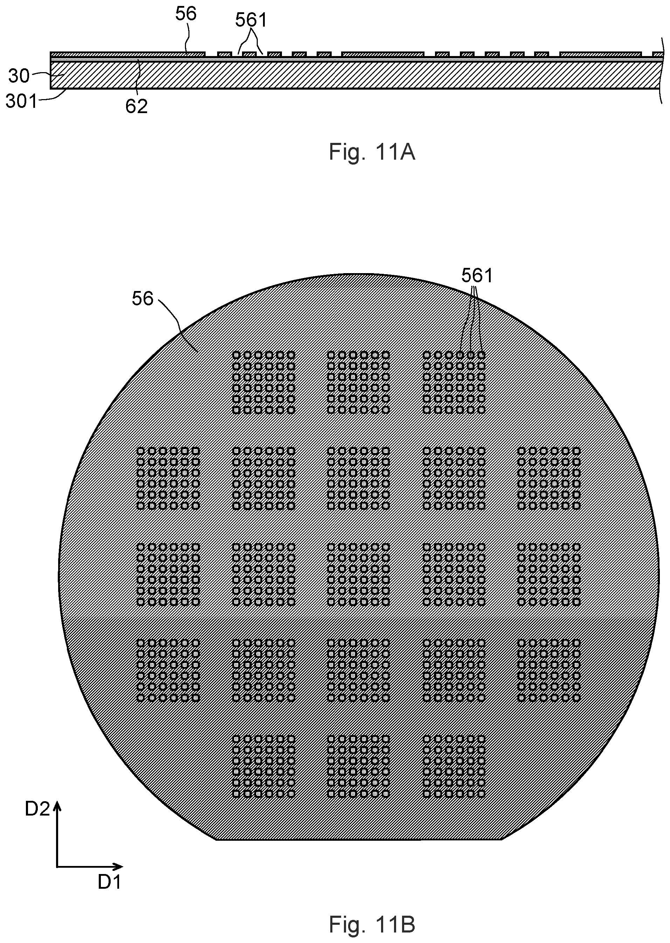

Subsequently, multiple through-holes 561 are formed in the first non-magnetic layer 56. Fig. 11A and Fig. 11B are sectional and plan views of the first non-magnetic layer 56 in which the multiple through-holes 561 are formed. The multiple through-holes 561 may be arranged in the first direction D1 and the second direction D2. The arrangement of the multiple through-holes 561 corresponds to the arrangement of the multiple second openings 41 of the multilayer body 40 in plan view.

A method of forming the through-holes 561 in the first non-magnetic layer 56 is not particularly limited. For example, the through-holes 561 may be formed by dry etching in which etching gas is used. The dry etching may be reactive ion etching.

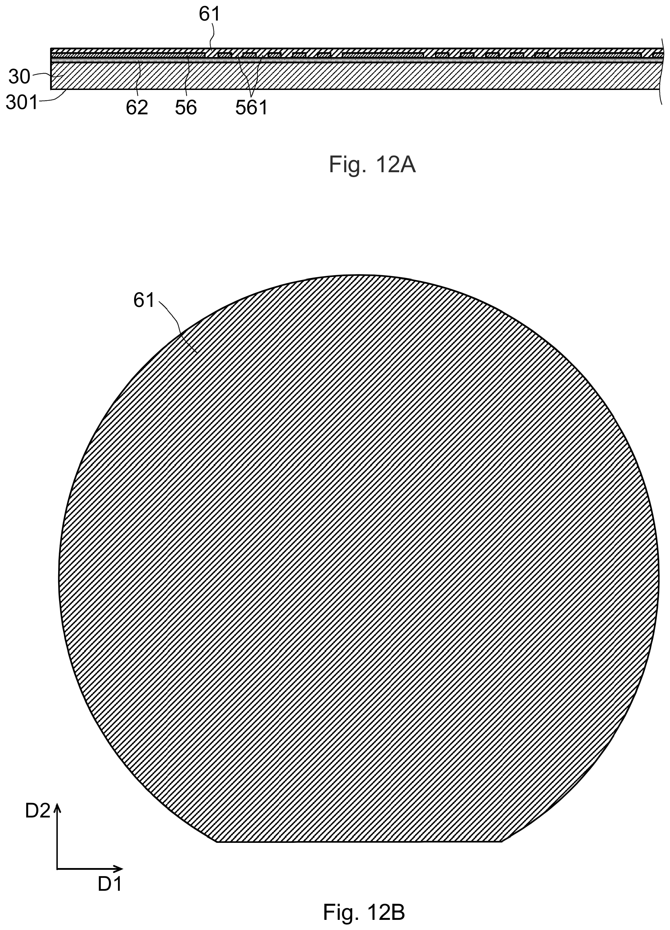

Subsequently, a step of forming the first intermediate layer 61 is performed. Fig. 12A and Fig. 12B are sectional and plan views of the first intermediate layer 61. In an example illustrated in Fig. 12A and Fig. 12B, the first intermediate layer 61 is formed on the first non-magnetic layer 56. The first intermediate layer 61 may cover the first non-magnetic layer 56 and the multiple through-holes 561. For example, the first intermediate layer 61 may be formed by using a physical film formation method such as a sputtering method, a vapor deposition method, or an ion plating method.

Subsequently, an insulating layer formation step at which the insulating layer 65 is formed on the first intermediate layer 61 is performed. The insulating layer 65 may be formed by using the chemical vapor deposition method. For example, in the case where the insulating layer 65 contains a silicon oxide, the insulating layer 65 may be formed by using the chemical vapor deposition method in which tetraethyl orthosilicate Si (OC₂H₅)₄ is used as a material.

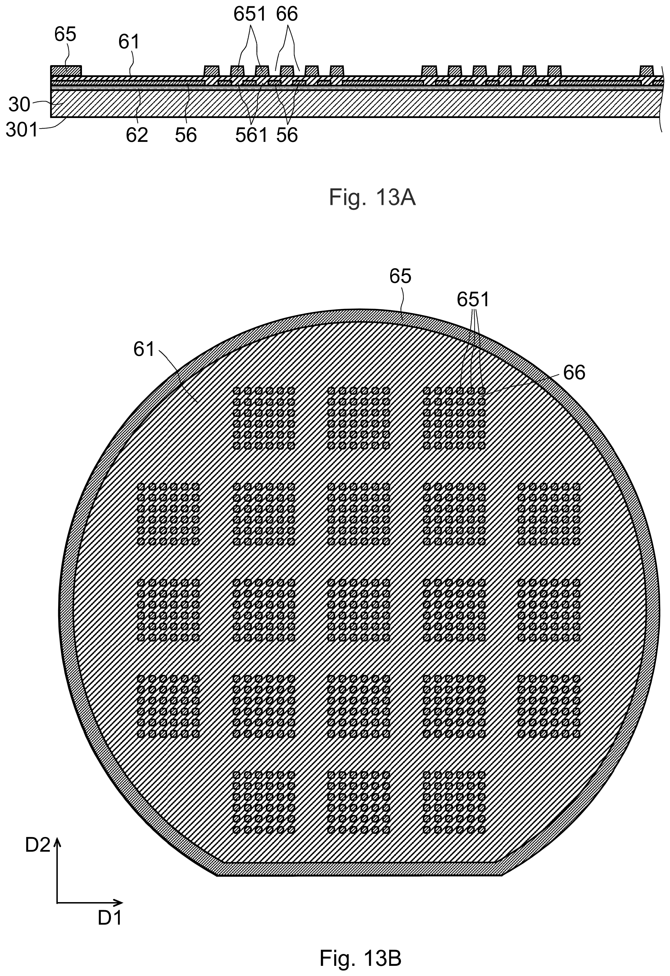

At the insulating layer formation step, insulating openings 66 are formed in the insulating layer 65. Fig. 13A and Fig. 13B are sectional and plan views of the insulating layer 65 in which the insulating openings 66 are formed.

As illustrated in Fig. 13A and Fig. 13B, the insulating layer 65 may include multiple insulating portions 651 that are arranged in the plane direction of the base material 30. The insulating layer 65 is divided into multiple portions due to the insulating openings 66, and consequently, the multiple insulating portions 651 are formed. As illustrated in Fig. 13A, the multiple insulating portions 651 may overlap the multiple through-holes 561 of the first non-magnetic layer 56 in plan view. One of the insulating portions 651 may overlap one of the through-holes 561. The arrangement of the multiple insulating portions 651 corresponds to the arrangement of the multiple second openings 41 of the multilayer body 40 in plan view. The through-holes of the magnetic layer 50 are formed at the positions of the insulating portions 651.

A method of forming the insulating openings 66 in the insulating layer 65 is not particularly limited. For example, the insulating openings 66 may be formed by dry etching in which etching gas is used. The dry etching may be reactive ion etching.

As illustrated in Fig. 13A and Fig. 13B, the insulating layer 65 may include a portion that extends along the outer edge of the base material 30 in plan view in addition to the multiple insulating portions 651.

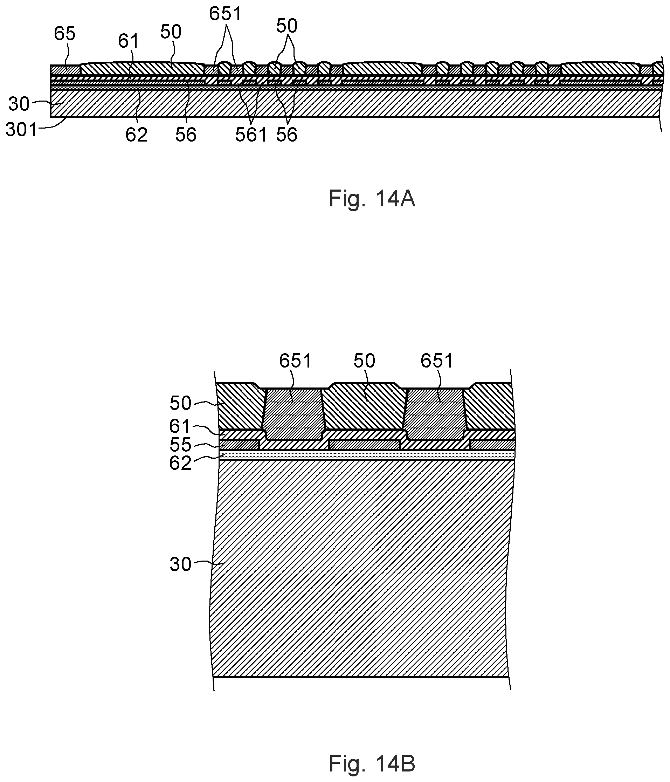

Subsequently, a magnetic layer formation step at which the magnetic layer 50 is formed is performed. At the magnetic layer formation step, as illustrated in Fig. 14A, the magnetic layer 50 is formed in gaps of the multiple insulating portions 651, that is, in the insulating openings 66.

The magnetic layer formation step may include a plating step. That is, the magnetic layer 50 may be formed at a plating step. The plating step may be an electroplating step or an electroless plating step. In the case where the electroplating step is performed, the first intermediate layer 61 functions as the seed layer. In the case where the electroplating step is performed, a hole or a cut portion for supplying electric current to the first intermediate layer 61 may be formed in the insulating layer 65 that is located along the outer edge of the base material 30.

At the plating step, a plating solution that contains metal ions for forming the magnetic layer 50 is supplied to the gaps of the multiple insulating portions 651. As a result, the magnetic layer 50 is formed in the gaps of the multiple insulating portions 651. Fig. 14B is a sectional view of an example of the magnetic layer 50. The magnetic layer 50 may project upward from the upper surface of the insulating layer 65 in the thickness direction of the base material 30. That is, the upper surface of the magnetic layer 50 may be located above the upper surface of the insulating layer 65.

As illustrated in Fig. 14B, the upper surface of the first intermediate layer 61 may have a step caused by the first non-magnetic layer 56. The insulating portions 651 of the insulating layer 65 may overlap the step of the upper surface of the first intermediate layer 61.

The magnetic layer formation step may include an annealing step at which the magnetic layer 50 is heated. The annealing step enables distortion that is created in the magnetic layer 50 to be reduced. At the annealing step, the base material 30, the magnetic layer 50, the first non-magnetic layer 56, and the insulating layer 65 are maintained in environments at a temperature higher than the room temperature. For example, the temperature at the annealing step is 120°C or more, may be 140°C or more, or may be 150°C or more. For example, the temperature at the annealing step is 250°C or less, may be 220°C or less, or may be 200°C or less.

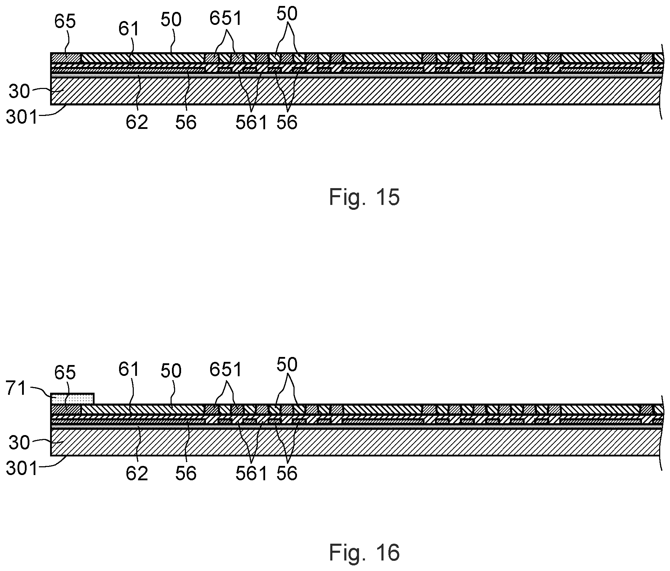

Subsequently, a polishing step may be performed. At the polishing step, a portion of the magnetic layer 50 that projects upward from the upper surface of the insulating layer 65 is polished. Fig. 15 is a sectional view of the magnetic layer 50 that is polished.

At the polishing step, the magnetic layer 50 may be polished by chemical mechanical polishing. The polishing step may be continued until the polishing surface of a polishing tool reaches the upper surface of the insulating layer 65 in the thickness direction. As a result, the upper surface of the magnetic layer 50 is flush with the upper surface of the insulating layer 65. For example, a distance between the position of the upper surface of the magnetic layer 50 and the position of the upper surface of the insulating layer 65 in the thickness direction of the base material 30 is 0.10 µm or less.

Subsequently, an insulating layer removal step at which a portion of the insulating layer 65 is removed is performed. At the insulating layer removal step, as illustrated in Fig. 16, a first protection layer 71 that covers the insulating layer 65 extending along the outer edge of the base material 30 may be formed. The first protection layer 71 may not cover the multiple insulating portions 651 that overlap the multiple through-holes 561 of the first non-magnetic layer 56. The first protection layer 71 may not cover the magnetic layer 50.

The first protection layer 71 has resistance against an etching solution for removing the insulating layer 65. For example, in the case where the etching solution contains buffered hydrofluoric acid, the first protection layer 71 contains resin that has resistance against hydrofluoric acid. For example, the first protection layer 71 contains photoresist that has resistance against hydrofluoric acid. For example, the photoresist may contain polyimide. A buffered hydrofluoric acid solution may be a solution that contains hydrofluoric acid and ammonium fluoride.

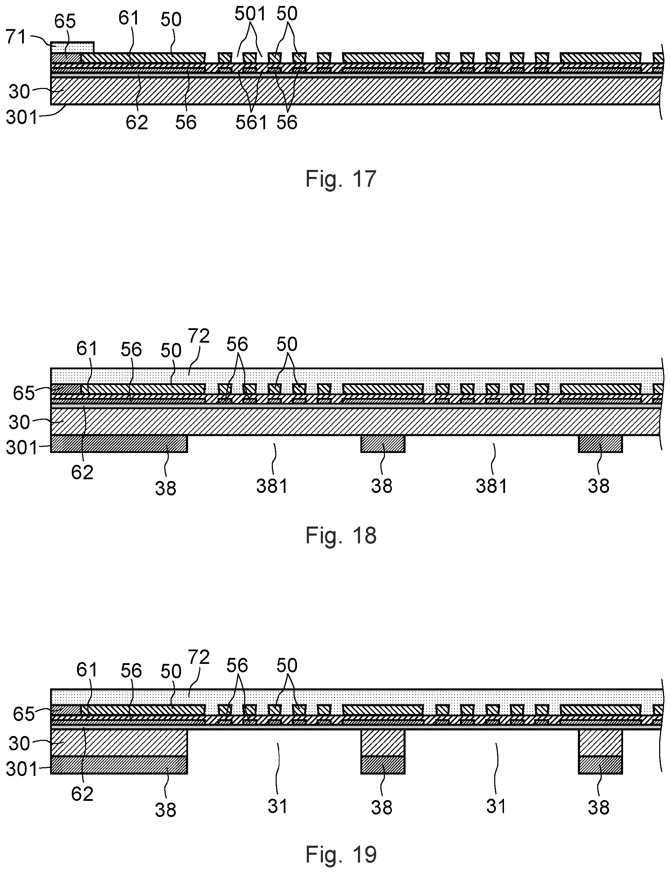

At the insulating layer removal step, an etching solution such as a buffered hydrofluoric acid solution is supplied to the insulating layer 65. As illustrated in Fig. 17, the etching solution removes the multiple insulating portions 651 that are not covered by the first protection layer 71. Consequently, multiple through-holes 501 that overlap the through-holes 561 of the first non-magnetic layer 56 in plan view are formed in the magnetic layer 50.

Subsequently, a base material processing step at which the first openings 31 are formed in the base material 30 is performed. At the base material processing step, as illustrated in Fig. 18, a resist layer 38 may be partly formed on the base-material first surface 301. Resist openings 381 are formed in a portion of the resist layer 38 that corresponds to the first openings 31. As illustrated in Fig. 18, a second protection layer 72 that covers the magnetic layer 50 and the insulating layer 65 may be formed.

The resist layer 38 may be photoresist. In this case, a liquid resist material is first coated on the base-material first surface 301, and consequently, the resist layer 38 is formed on the base-material first surface 301. After coating, a step of heating the resist layer 38 may be performed. Subsequently, a photolithography process in which the resist layer 38 is exposed to light and is developed is performed. This enables the resist openings 381 to be formed in the resist layer 38.

The resist layer 38 may be a silicon oxide film that is partly formed on the base-material first surface 301 although this is not illustrated. For example, the silicon oxide film is formed in a manner in which a thermal oxidation treatment is partly performed on the base-material first surface 301. The silicon oxide film may be formed on the base material 30 before an intermediate layer 60 is stacked on the base material 30.

Subsequently, as illustrated in Fig. 19, the base material 30 is etched from the base-material first surface 301, and consequently, the first openings 31 are formed in the base material 30 at the base material processing step. Etching may be dry etching in which etching gas is used. Since the second intermediate layer 62 has resistance against the etchant, as illustrated in Fig. 19, etching can be inhibited from progressing up to the first intermediate layer 61 and the magnetic layer 50. An example of the etching gas is SF₆ gas.

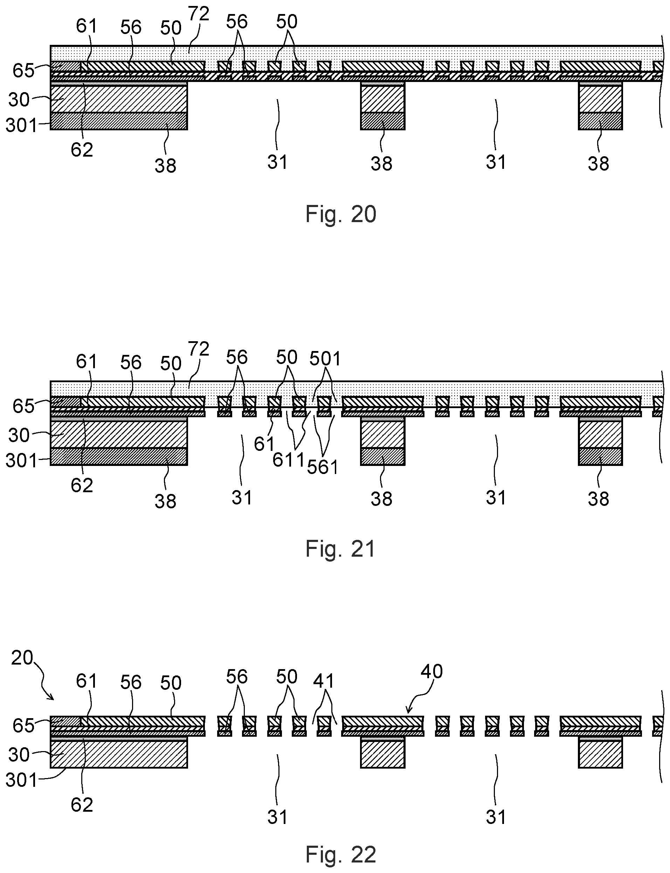

Subsequently, as illustrated in Fig. 20, a second intermediate layer removal step at which a portion of the second intermediate layer 62 is removed is performed. The second intermediate layer removal step is performed in a manner in which an etchant for the second intermediate layer 62 is supplied to the first openings 31. As a result of the second intermediate layer removal step, the second intermediate layer 62 that overlaps the first openings 31 in plan view is removed. The second intermediate layer 62 may be removed by dry etching in which fluorine gas, for example, is used or wet etching in which an acidic etching solution is used.

As illustrated in Fig. 21, a first intermediate layer removal step at which a portion of the first intermediate layer 61 is removed is performed. The first intermediate layer removal step is performed in a manner in which an etchant for the first intermediate layer 61 is supplied to the first openings 31. As a result of the first intermediate layer removal step, the first intermediate layer 61 that overlaps the first openings 31 and that does not overlap the first non-magnetic layer 56 in plan view is removed. As a result, multiple through-holes 611 that overlap the through-holes 561 of the first non-magnetic layer 56 and the through-holes 501 of the magnetic layer 50 in plan view are formed in the first intermediate layer 61.

A resist removal step at which the resist layer 38 is removed and a second protection layer removal step at which the second protection layer 72 is removed are performed. The order of the resist removal step, the second protection layer removal step, and the intermediate layer removal step is not particularly limited. Fig. 22 is a sectional view in which the resist removal step and the second protection layer removal step are performed.

In the case where the resist layer 38 is photoresist, a resist processing liquid that contains N-methyl-2-pyrrolidone may be supplied to the resist layer 38. The resist layer 38 may be removed in a manner in which the resist layer 38 is irradiated with oxygen plasma. In the case where the resist layer 38 is a silicon oxide film, a resist processing liquid that contains hydrofluoric acid may be supplied to the resist layer 38. The resist layer 38 may be removed by dry etching in which CF₄ gas is used.

As illustrated in Fig. 22, the mask 20 includes the second openings 41 that extend through the multilayer body 40. The multilayer body 40 includes, at positions overlapping the first openings 31 in plan view, at least the magnetic layer 50 and the first non-magnetic layer 56 that is stacked on the magnetic layer 50. The first non-magnetic layer 56 is capable of inhibiting the magnetic layer 50 from changing due to, for example, a change in temperature. Accordingly, the dimensions or positions of the second openings 41 of the multilayer body 40 are inhibited from changing due to, for example, a change in temperature.

An embodiment described above can be modified in various ways. Modifications will now be described with reference to the drawings as needed. In the description below and the drawings that are used for the description below, as for a portion that can be the same as in an embodiment described above, the same reference sign as the reference sign that is used for a corresponding portion according to an embodiment described above is used. A duplicated description is omitted. In the case where the actions and the effects that are obtained according to an embodiment described above are obviously obtained also according to the modifications, the description thereof is omitted in some cases.

### (First Modification)

In an example described below, the magnetic layer formation step includes a physical film formation step.

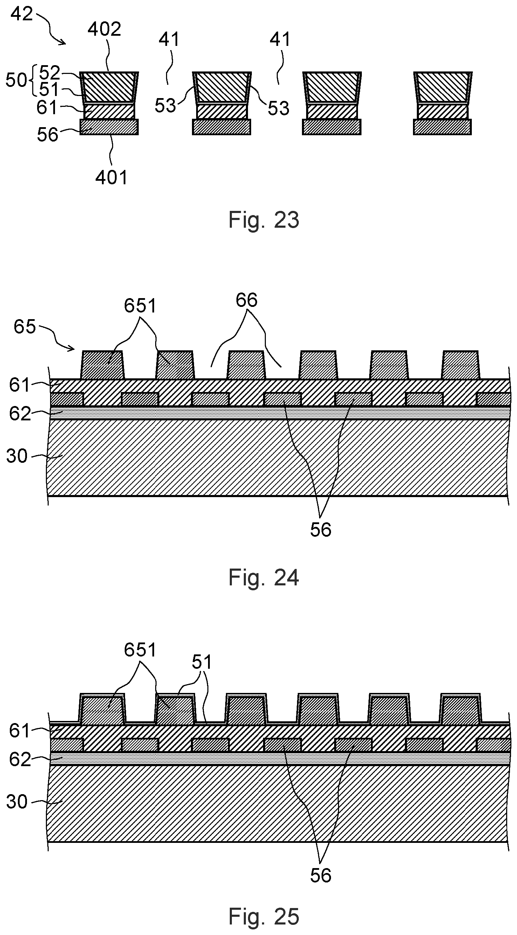

Fig. 23 is a sectional view of an example of a pattern region 42 of the mask 20 according to a first modification. The magnetic layer 50 may include a first layer 51 and a second layer 52.

The first layer 51 is formed at the physical film formation step such as a sputtering step. The second layer 52 is formed at a plating step. For example, the second layer 52 is formed at an electroplating step. In this case, the first layer 51 functions as a seed layer.

The material of the first layer 51 may be the same as the material of the second layer 52. For example, the first layer 51 and the second layer 52 may contain, as a main component, nickel. Alternatively, the material of the first layer 51 may differ from the material of the second layer 52.

A method of manufacturing the mask 20 according to the first modification will be described. The steps for forming the second intermediate layer 62, the first non-magnetic layer 56, and the first intermediate layer 61 on the base material 30 are the same as those in the case of the embodiment described above. Accordingly, the description for the steps is omitted.

Fig. 24 is a sectional view for describing the insulating layer formation step at which the insulating layer 65 is formed on the first intermediate layer 61. The insulating layer 65 contains the multiple insulating portions 651.

Fig. 25 is a sectional view for describing the physical film formation step at which the first layer 51 is formed. For example, the first layer 51 is formed on the side surface and upper surface of the insulating layer 65 and the upper surface of the first intermediate layer 61 that is located at the insulating openings 66.

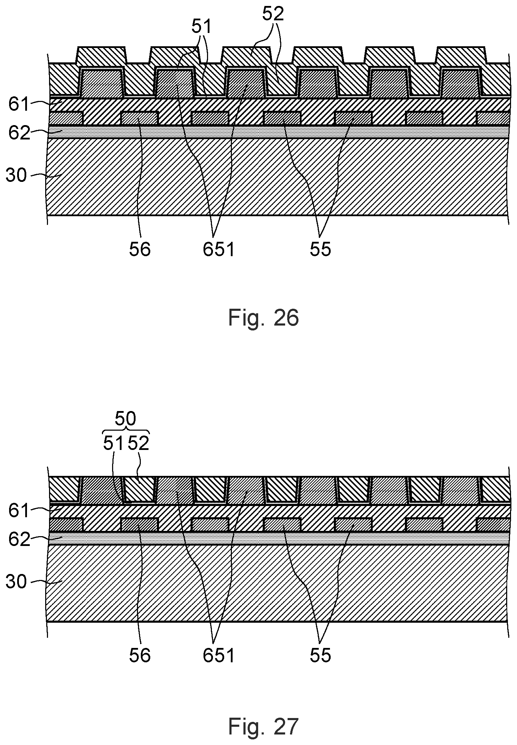

Fig. 26 is a sectional view for describing the plating step at which the second layer 52 is formed. The second layer 52 is formed on the first layer 51.

Fig. 27 is a sectional view for describing the polishing step. The polishing step may be continued until the polishing surface of the polishing tool reaches the upper surface of the insulating layer 65 in the thickness direction. As a result, the upper surface of the magnetic layer 50 is flush with the upper surface of the insulating layer 65. The magnetic layer 50 includes the second layer 52 and the first layer 51 that is located between the second layer 52 and the insulating layer 65 and between the second layer 52 and the first intermediate layer 61.

Subsequently, a step of removing a portion of the insulating layer 65, a step of removing a portion of the base material 30, a step of removing a portion of the second intermediate layer 62, and a step of removing a portion of the first intermediate layer 61 are performed. The steps are the same as those in the case of the embodiment described above. Accordingly, the description for the steps is omitted.

The magnetic layer 50 may be formed only at a physical film formation step such as a sputtering step although this is not illustrated. In this case, the physical film formation step may be continued until the upper surface of the magnetic layer 50 that is formed in the insulating openings 66 at the physical film formation step reaches a position above the upper surface of the insulating layer 65. Subsequently, the polishing step may be performed.

### (Second Modification)

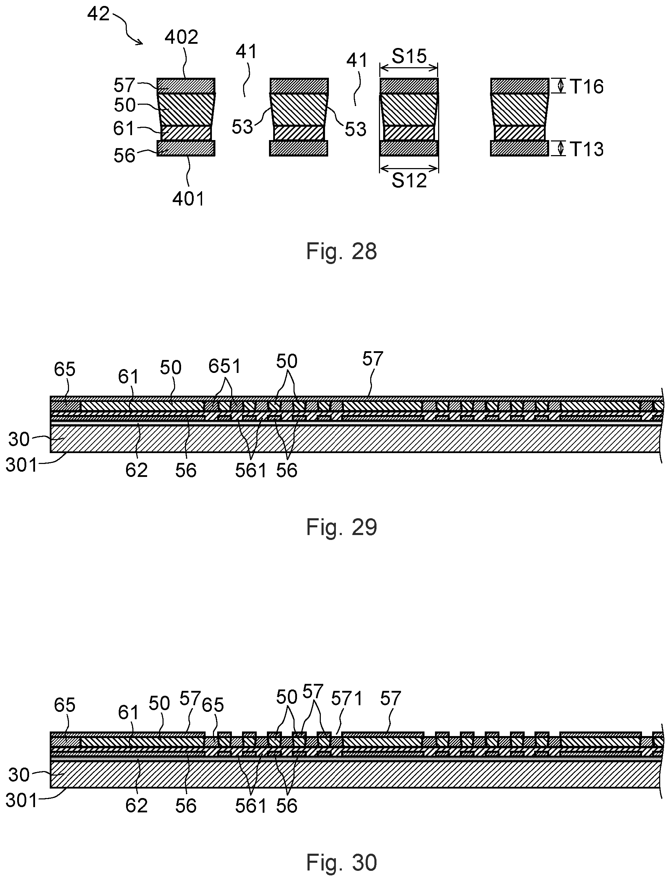

Fig. 28 is a sectional view of an example of a pattern region 42 according to a second modification. The pattern region 42 may contain a second non-magnetic layer 57 that is located between the magnetic layer 50 and the second surface 402. The second openings 41 may extend through the first non-magnetic layer 56, the first intermediate layer 61, the magnetic layer 50, and the second non-magnetic layer 57. The first surface 401 of the pattern region 42 may be formed by the first non-magnetic layer 56. The second surface 402 of the pattern region 42 may be formed by the second non-magnetic layer 57.

In Fig. 28, a reference sign of S15 represents a dimension of the second non-magnetic layer 57 at the upper surface. The dimension S15 may be smaller than the dimension S12 of the upper surface of the magnetic layer 50. As the dimension S15 decreases, shadow due to the second non-magnetic layer 57 can be further inhibited from occurring.

The second non-magnetic layer 57, as in the first non-magnetic layer 56, is composed of a non-magnetic material that does not possess magnetism. For example, the second non-magnetic layer 57 contains, as a main material, an inorganic material that has insulation properties such as a silicon oxide or a silicon nitride.

For example, the thickness T16 of the second non-magnetic layer 57 is 50 nm or more, may be 100 nm or more, or may be 200 nm or more. For example, the thickness T16 is 1000 nm or less, may be 700 nm or less, or may be 500 nm or less.

The thickness T16 of the second non-magnetic layer 57 may be defined relative to the thickness T11 of the magnetic layer 50 such that the magnetic layer 50 is inhibited from changing. For example, T16/T11 that is the ratio of the thickness T16 of the second non-magnetic layer 57 to the thickness T11 of the magnetic layer 50 is 0.05 or more, may be 0.10 or more, or may be 0.15 or more. For example, T16/T11 is 0.50 or less, may be 0.40 or less, or may be 0.30 or less.

A method of manufacturing the mask 20 according to the second modification will be described. The steps for forming the second intermediate layer 62, the first non-magnetic layer 56, the first intermediate layer 61, the insulating layer 65, and the magnetic layer 50 on the base material 30 and the polishing step are the same as those in the case of the embodiment described above. Accordingly, the description for the steps is omitted.

Fig. 29 is a sectional view for describing the second non-magnetic layer formation step at which the second non-magnetic layer 57 is formed on the magnetic layer 50 and the insulating layer 65. The second non-magnetic layer 57 may be formed by using a chemical vapor deposition method as in the first non-magnetic layer 56. For example, in the case where the second non-magnetic layer 57 contains a silicon oxide, the second non-magnetic layer 57 may be formed by using the chemical vapor deposition method in which tetraethyl orthosilicate Si (OC₂H₅)₄ is used as a material.

Subsequently, as illustrated in Fig. 30, multiple through-holes 571 are formed in the second non-magnetic layer 57. The multiple through-holes 571 may arranged in the first direction D1 and the second direction D2. The arrangement of the multiple through-holes 571 corresponds to the arrangement of the multiple second openings 41 of the multilayer body 40 in plan view. The multiple through-holes 571 of the second non-magnetic layer 57 may overlap the respective through-holes 561 of the first non-magnetic layer 56 in plan view.

A method of forming the through-holes 571 in the second non-magnetic layer 57 is not particularly limited. For example, the through-holes 571 may be formed by dry etching in which etching gas is used. The dry etching may be reactive ion etching.

The step of removing a portion of the insulating layer 65, the step of removing a portion of the base material 30, the step of removing a portion of the second intermediate layer 62, and the step of removing a portion of the first intermediate layer 61 are the same as those in the case of the embodiment described above. Accordingly, the description for the steps is omitted.

According to the second modification, the mask 20 includes the second openings 41 that extend through the multilayer body 40 that includes the first non-magnetic layer 56, the first intermediate layer 61, the magnetic layer 50, and the second non-magnetic layer 57. The first non-magnetic layer 56 and the second non-magnetic layer 57 are capable of inhibiting the magnetic layer 50 from changing due to, for example, a change in temperature. Accordingly, the dimensions or positions of the second openings 41 of the multilayer body 40 are inhibited from changing due to, for example, a change in temperature.

### (Third Modification)

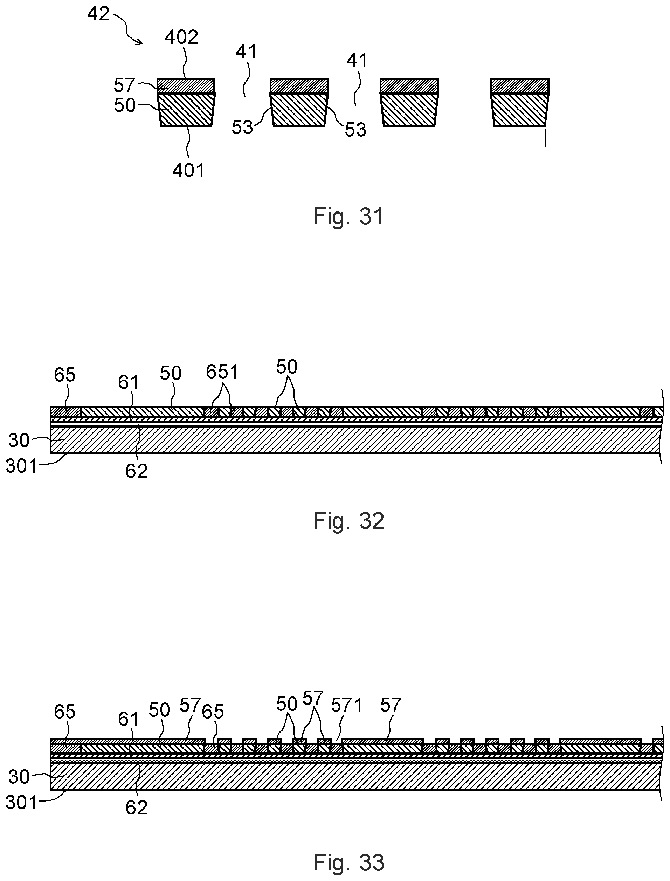

Fig. 31 is a sectional view of an example of a pattern region 42 according to a third modification. The pattern region 42 includes the second non-magnetic layer 57 that is located between the magnetic layer 50 and the second surface 402 but may not include the first non-magnetic layer 56. The first surface 401 of the pattern regions 42 may be formed by the magnetic layer 50. The second surface 402 of the pattern regions 42 may be formed by the second non-magnetic layer 57.

A method of manufacturing the mask 20 according to the third modification will be described. The steps for forming the second intermediate layer 62, the first intermediate layer 61, the insulating layer 65, and the magnetic layer 50 on the base material 30 are performed. Subsequently, as illustrated in Fig. 32, the polishing step is performed.

Subsequently, as illustrated in Fig. 33, the second non-magnetic layer formation step at which the second non-magnetic layer 57 is formed is performed. At the second non-magnetic layer formation step, the second non-magnetic layer 57 is formed on the magnetic layer 50 and the insulating layer 65 as in the case of the second modification. Subsequently, the multiple through-holes 571 are formed in the second non-magnetic layer 57 as in the case of the second modification. The multiple through-holes 571 may be arranged in the first direction D1 and the second direction D2. The arrangement of the multiple through-holes 571 corresponds to the arrangement of the multiple second openings 41 of the multilayer body 40 in plan view.

Subsequently, the step of removing a portion of the insulating layer 65, the step of removing a portion of the base material 30, and the step of removing a portion of the second intermediate layer 62 are performed. Subsequently, the step of removing a portion of the first intermediate layer 61 is performed. According to the third modification, the first intermediate layer 61 that overlaps the first openings 31 in plan view may be removed. As a result, the pattern regions 42 of the mask 20 illustrated in Fig. 31 are obtained.

The mask 20 according to the third modification may include only one of the first intermediate layer 61 and the second intermediate layer 62 although this is not illustrated. One of the first intermediate layer 61 and the second intermediate layer 62 functions as an intermediate layer for stopping etching at the step of processing the base material 30 by etching.

### (Fourth Modification)

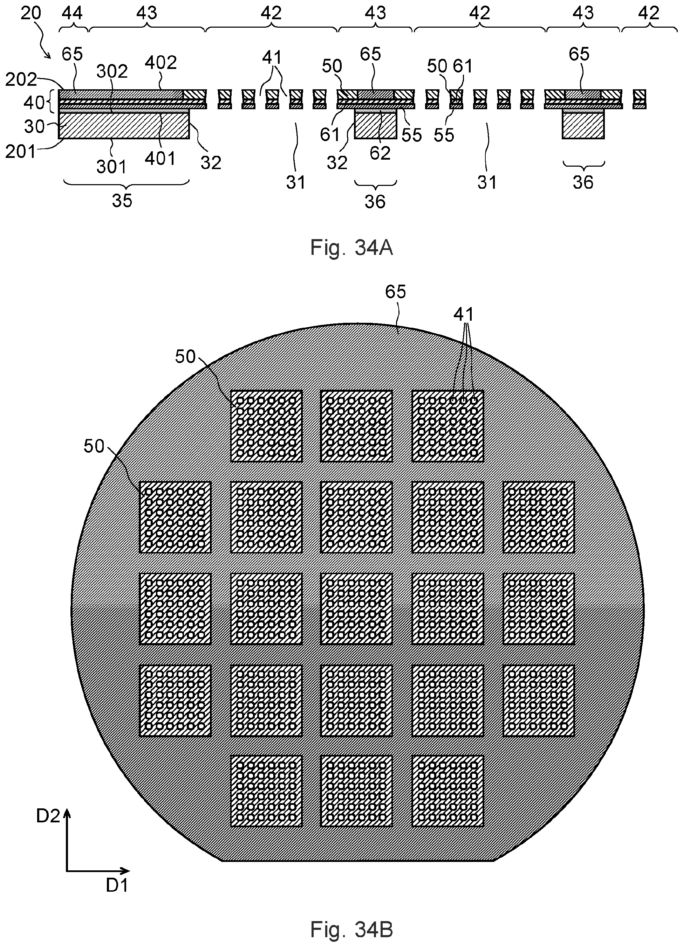

Fig. 34A and Fig. 34B are sectional and plan views of an example of the mask 20 according to a fourth modification. The surrounding region(s) 43 of the multilayer body 40 may include the insulating layer 65 that is flush with the magnetic layer 50 in the pattern regions 42. For example, the lower surface of the insulating layer 65 in the surrounding region(s) 43 may be located on the first intermediate layer 61 as in the lower surface of the magnetic layer 50 in the pattern regions 42. The side surface of the insulating layer 65 in the surrounding region(s) 43 may be in contact with the side surface of the magnetic layer 50. As illustrated in Fig. 34B, the insulating layer 65 may surround the magnetic layer 50 in the pattern regions 42 in plan view.

A method of manufacturing the mask 20 according to the fourth modification will be described. The steps for forming the second intermediate layer 62, the first non-magnetic layer 56, and the first intermediate layer 61 on the base material 30 are the same as those in the case of the embodiment described above. Accordingly, the description for the steps is omitted.

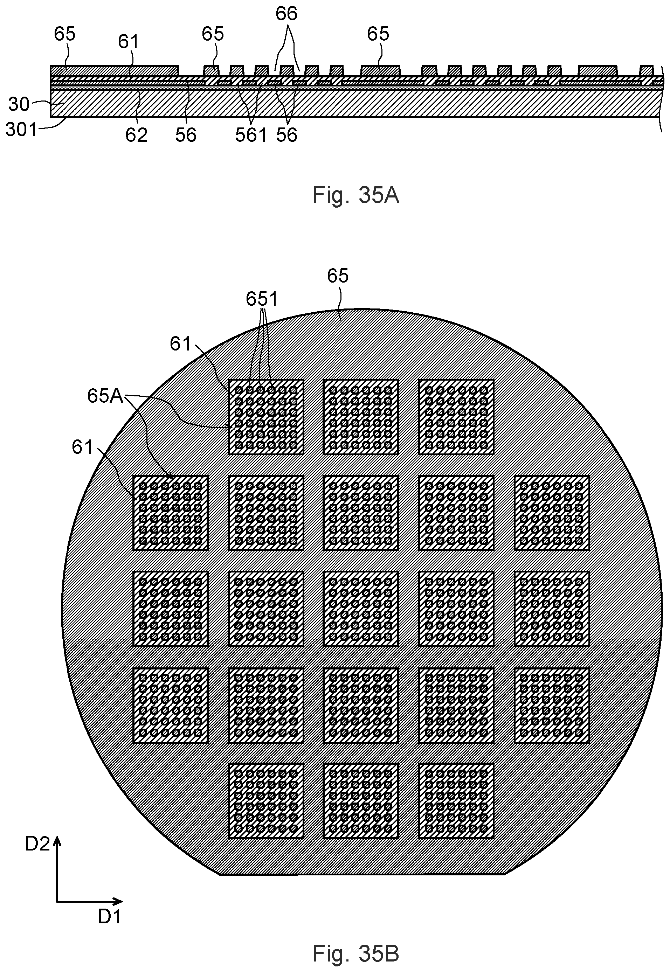

Fig. 35A and Fig. 35B are sectional and plan views for describing the insulating layer formation step at which the insulating layer 65 is formed on the first intermediate layer 61. The insulating layer 65 includes multiple insulating portion groups 65A that are arranged along the base-material first surface 301. For example, the multiple insulating portion groups 65A are arranged in the first direction D1 and the second direction D2. Each of the insulating portion groups 65A includes multiple insulating portions 651. The insulating layer 65 includes a portion that surrounds the multiple insulating portion groups 65A in plan view.

Subsequently, the magnetic layer formation step at which the magnetic layer 50 is formed in the gaps of the multiple insulating portions 651 is performed. Subsequently, the polishing step, the insulating layer removal step, the step of removing a portion of the base material 30, the step of removing a portion of the second intermediate layer 62, and the step of removing a portion of the first intermediate layer 61 are performed. At the insulating layer removal step, the multiple insulating portion groups 65A are removed, but the portion of the insulating layer 65 that surrounds the multiple insulating portion groups 65A in plan view is not removed but remains. As a result, the mask 20 illustrated in Fig. 34A and Fig. 34B is obtained.

The surrounding region(s) 43 contain the insulating layer 65, and consequently, the insulating layer 65 cancels out the force that is applied by the magnetic layer 50 to the base material 30. Accordingly, the mask 20 can be inhibited from warping.

### (Fifth Modification)

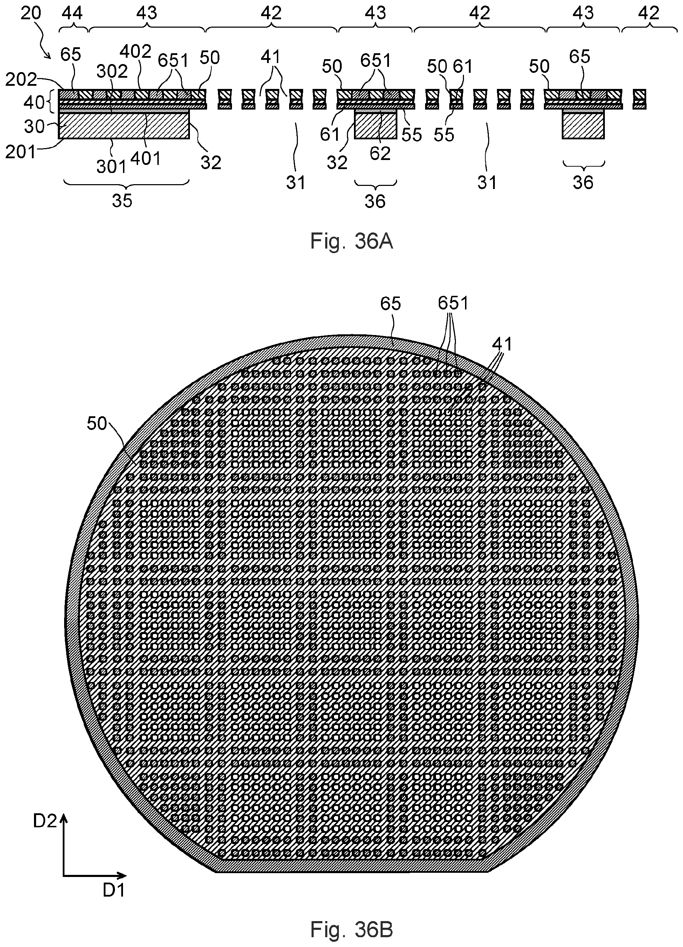

Fig. 36A and Fig. 36B are sectional and plan views of an example of the mask 20 according to a fifth modification. The surrounding region(s) 43 of the multilayer body 40 may contain the insulating layer 65 that is flush with the magnetic layer 50 in the pattern regions 42. The insulating layer 65 in the surrounding region(s) 43 may include the multiple insulating portions 651 that are distributed in the plane direction of the base-material second surface 302. The surrounding region(s) 43 may contain the magnetic layer 50 that is located in the gaps of the multiple insulating portions 651.

A method of manufacturing the mask 20 according to the fifth modification will be described. The steps for forming the second intermediate layer 62, the first non-magnetic layer 56, and the first intermediate layer 61 on the base material 30 are the same as those in the case of the embodiment described above. Accordingly, the description for the steps is omitted.

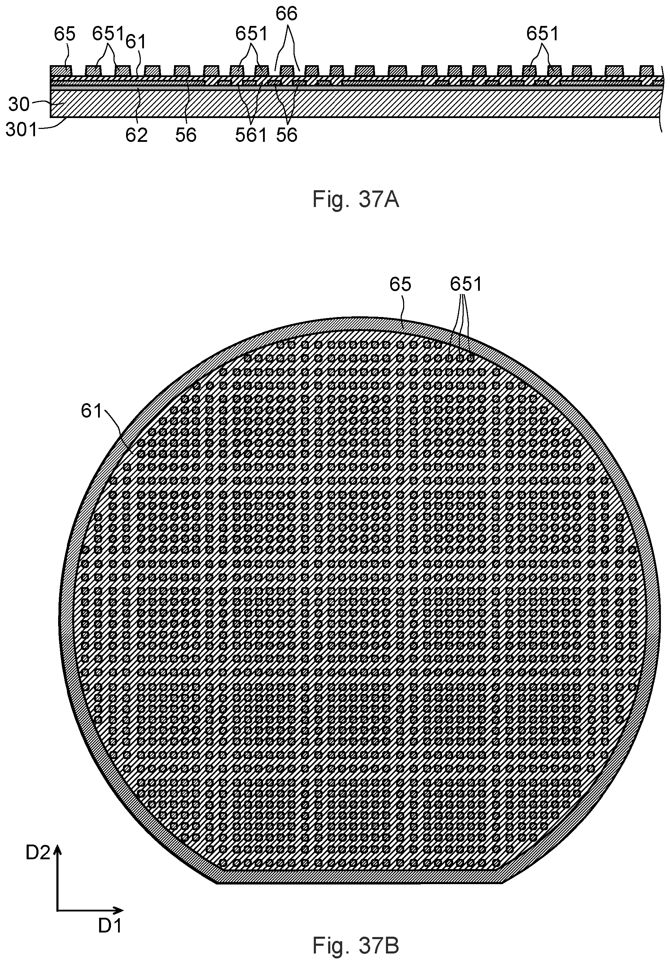

Fig. 37A and Fig. 37B are sectional and plan views for describing the insulating layer formation step at which the insulating layer 65 is formed on the first intermediate layer 61. The insulating layer 65 includes the multiple insulating portions 651 that are arranged along the base-material first surface 301. The multiple insulating portions 651 are distributed in a region corresponding to the surrounding region(s) 43 and the pattern regions 42 of the multilayer body 40.

Subsequently, the magnetic layer formation step at which the magnetic layer 50 is formed in the gaps of the multiple insulating portions 651 is performed. Since the multiple insulating portions 651 are distributed in a wide range, the density of the magnetic layer 50 that is formed on the base material 30 is uniform across a wide range. Accordingly, the distribution of stress that is applied to the base material 30 due to the magnetic layer 50 is uniform.

Subsequently, the polishing step, the insulating layer removal step, the step of removing a portion of the base material 30, the step of removing a portion of the second intermediate layer 62, and the step of removing a portion of the first intermediate layer 61 are performed. At the insulating layer removal step, multiple insulating portions 651 that overlap the first openings 31 are removed, but multiple insulating portions 651 that do not overlap the first openings 31 are not removed but remain. As a result, the mask 20 that includes multiple insulating portions 651 that are located in the surrounding region(s) 43 and that are distributed in the plane direction of the base-material second surface 302 is obtained as illustrated in Fig. 36A and Fig. 36B.

The distribution of the stress that is applied to the base material 30 due to the magnetic layer 50 is uniform, and accordingly, the mask 20 can be inhibited from warping.

### (Sixth Modification)

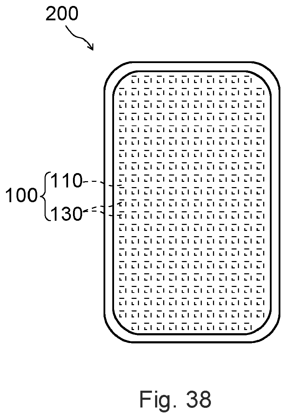

Fig. 38 illustrates an example of a device 200 that includes the organic device 100. The device 200 includes the substrate 110 and the organic layers 130. The organic layers 130 are formed by using the vapor deposition method in which the mask 20 is used. An example of the device 200 is a smart phone. The device 200 may be a tablet terminal or a wearable terminal. Examples of the wearable terminal include smart glasses and a head-mounted display.

Multiple components that are disclosed according to the embodiments and the modifications described above can be appropriately combined as needed. Some of components may be removed from all of the components that are disclosed according to the embodiments and the modifications described above.

## Claims

1. A mask comprising:
a base material that includes a base-material first surface, a base-material second surface located opposite the base-material first surface, and at least one first opening that extends from the base-material first surface to the base-material second surface; and
a multilayer body including a magnetic layer that includes a first surface facing the base-material second surface and a second surface located opposite the first surface and that contains magnetic metal and a non-magnetic layer located between the magnetic layer and the first surface or between the magnetic layer and the second surface,
wherein the multilayer body includes a pattern region that overlaps the first opening in plan view and that includes multiple second openings extending through the magnetic layer and the non-magnetic layer, a surrounding region that surrounds the pattern region in plan view, and an outer edge region that surrounds the surrounding region in plan view and that is located along an outer edge of the multilayer body.

2. The mask according to claim 1, wherein the non-magnetic layer has an insulation property.

3. The mask according to claim 1, wherein the non-magnetic layer contains a silicon oxide or a silicon nitride.

4. The mask according to claim 1, wherein the base material contains silicon or a silicon compound.

5. The mask according to any one of claim 1 to claim 4, wherein the non-magnetic layer includes a first non-magnetic layer that is located between the magnetic layer and the first surface.

6. The mask according to claim 5, wherein the multilayer body includes a first intermediate layer that is located between the first non-magnetic layer and the magnetic layer and that contains metal.

7. The mask according to claim 5, wherein the surrounding region of the multilayer body contains a second intermediate layer that is located between the first non-magnetic layer and the base-material second surface.

8. The mask according to any one of claim 1 to claim 4, wherein the surrounding region of the multilayer body contains an insulating layer that is flush with the magnetic layer of the pattern region.

9. The mask according to claim 8, wherein the insulating layer in the surrounding region includes multiple insulating portions that are distributed in a plane direction of the base-material second surface, and
wherein the surrounding region contains the magnetic layer that is located in gaps of the multiple insulating portions.

10. The mask according to any one of claim 1 to claim 4, wherein the non-magnetic layer includes a second non-magnetic layer that is located between the magnetic layer and the second surface.

11. A method of manufacturing a mask, the method comprising:
a base material preparation step of preparing a base material that includes a base-material first surface and a base-material second surface located opposite the base-material first surface;
a first non-magnetic layer formation step of forming a first non-magnetic layer that faces the base-material second surface and that includes multiple through-holes;
an insulating layer formation step of forming an insulating layer that includes multiple insulating portions overlapping the respective through-holes of the first non-magnetic layer in plan view;
a magnetic layer formation step of forming a magnetic layer in gaps of the multiple insulating portions;
an insulating layer removal step of removing the multiple insulating portions; and
a base material processing step of forming, in the base material, a first opening that overlaps the multiple through-holes of the first non-magnetic layer in plan view.

12. The method according to claim 11, further comprising: a step of forming a first intermediate layer that covers the first non-magnetic layer and that contains metal,
wherein at the insulating layer formation step, the insulating layer is formed on the first intermediate layer.

13. The method according to claim 11, further comprising: a step of forming a second intermediate layer that is located on the base-material second surface,
wherein at the first non-magnetic layer formation step, the first non-magnetic layer is formed on the second intermediate layer.

14. The method according to claim 11, wherein the first non-magnetic layer contains a silicon oxide or a silicon nitride.

15. A method of manufacturing a mask, the method comprising:
a base material preparation step of preparing a base material that includes a base-material first surface and a base-material second surface located opposite the base-material first surface;
an insulating layer formation step of forming an insulating layer that includes multiple insulating portions that are distributed in a plane direction of the base-material second surface in plan view;
a magnetic layer formation step of forming a magnetic layer in gaps of the multiple insulating portions;
a second non-magnetic layer formation step of forming a second non-magnetic layer that includes through-holes overlapping the respective insulating portions in plan view;
an insulating layer removal step of removing the multiple insulating portions; and
a base material processing step of forming, in the base material, a first opening that overlaps the multiple through-holes of the second non-magnetic layer in plan view.

16. The method according to claim 15, further comprising: a step of forming an intermediate layer that is located on the base-material second surface and that contains metal,
wherein at the insulating layer formation step, the insulating layer is formed on the intermediate layer.

17. The method according to claim 15, wherein the second non-magnetic layer contains a silicon oxide or a silicon nitride.

18. The method according to any one of claim 11 to claim 17, wherein the base material contains silicon or a silicon compound.

19. The method according to any one of claim 11 to claim 17, wherein at the insulating layer removal step, the insulating layer remains so as not to overlap the first opening in plan view.

20. The method according to claim 19, wherein the insulating layer that remains after the insulating layer removal step includes the multiple insulating portions that are distributed in the plane direction of the base-material second surface.
